# EUROPEAN PATENT SPECIFICATION

(11) **EP 1 631 616 B1**
(45) Date of publication and mention of the grant of the patent: **05.10.2011**
(21) Application number: 04735241.4
(22) Date of filing: 28.05.2004
(51) Int. Cl.: C08G 77/38, G03F 7/075, C08F 2/50

(54) **NOVEL SURFACE-ACTIVE POLYSILOXANE PHOTOINITIATORS**
NEUE OBERFLÄCHENAKTIVE POLYSILOXANPHOTOINITIATOREN
NOUVEAUX PHOTO-INITIATEURS DE POLYSILOXANE A SURFACE ACTIVE

(30) Priority: 06.06.2003 EP 03405409
(43) Date of publication of application: 08.03.2006
(73) Proprietor: BASF SE, 67056 Ludwigshafen (DE)
(72) Inventor: ROGERS, Jonathan, White Plains, NY 10606 (US); BAUDIN, Gisèle, CH-4123 Allschwil (CH); JUNG, Tunja, 79618 Rheinfelden-Herten (DE); ÖHRLEIN, Reinhold, 79618 Rheinfelden-Herten (DE); BAISCH, Gabriele, 79589 Binzen (DE)
(86) International application number: PCT/EP2004/050952
(87) International publication number: WO 2004/108799

(56) References cited:
- WO-A-02/14439
- US-A- 4 507 187

## Description

The invention relates to novel surface-active polysiloxane photoinitiators and to a process for producing stable, scratch-resistant and/or chemical-resistant coatings using said siloxane photoinitiator.

The International Publication WO 02/14439 describes a process for producing coatings using siloxane photoinitiators, which accumulate at the surface.

It has now been found that a specific siloxane compound can provide improved through cure and scratch resistance.

Thus, the present invention relates to polymeric photoinitiators of the formula I or II 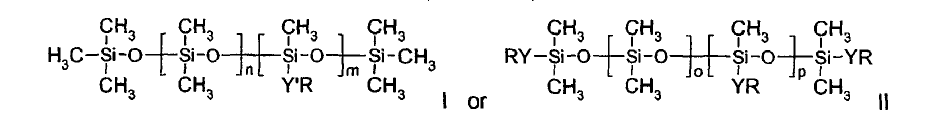 wherein
n and m independently of one another are 3-5;
o is 10-16;
p is 4-8;
R is phenyl-CO-CO-O-;
Y and Y' independently of one another are C₁-C₁₀alkylene or -[(CH₂)ₐ-O-(CH₂)_{b}]_{c}- wherein a is 2-10, b is 0-10, c is 1-3; with the proviso that they are, however, at least 1 if the methylene group in question is between two oxygen atoms.
"a" is especially 2 or 3; "b" is especially 1-3.

The values of the repeating units m, n, o and p are average numbers. In other words, the invention relates to polymeric photoinitiators of the formula I or II, where the siloxane backbone of the formula la or IIa 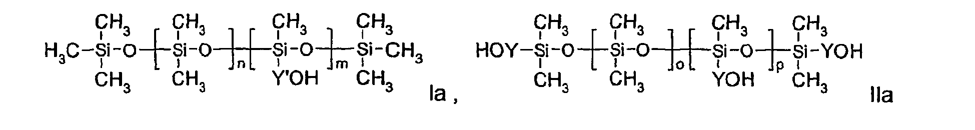 consists of a mixture of copolymers with the above mentioned average numbers n, m, o and p. Preferably n and m are approximately 4.

C₁-C₁₀Alkylene Y or Y' is linear or branched alkylene, for example C₁-C₈-, C₁-C₆-, C₁-C₄-, C₂-C₈-, C₂-C₄alkylene, such as methylene, ethylene, propylene, isopropylene, n-butylene, sec-butylene, iso-butylene, tert-butylene, pentylene, hexylene, heptylene, octylene, nonylene or decylene.

In particular, Y or Y' are, for example, ethylene, propylene, butylene, hexylene or octylene.

The compounds of the formula I or II may be prepared through esterification of phenyl-glyoxalic acid or through transesterification of methylphenylglyoxalate with a compound of the formula la or IIa 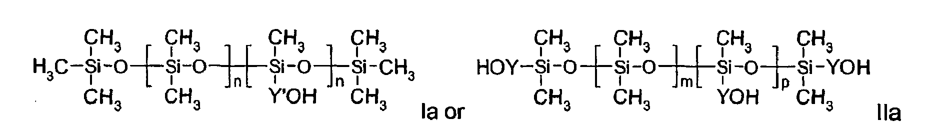 under esterification conditions or transesterification conditions common in the art.

The esterification is, for example, carried out in the presence of an acid or of coupling reagents of the Mitsunobu type, e.g. N,N'-dicyclohexylcarbodiimide (DCC) or 1,1'-carbonyldiimidazole (CDI) (coupling reagents of the Mitsunobu type are well known to the person skilled in the art and are described, for example, in Progress in the Mitsunobu reaction. A review. Org. Prep. Proced. Int. (1996), 28(2), 127-64 or in The Mitsunobu reaction. Org. React. (N. Y.) (1992), 42 335-656.

Common transesterification catalysts are, for example, selected from the group consisting of combinations of alkali metal salts of organic or inorganic acides with hydroxides. Suitable solvents are aliphatic or aromatic hydrocarbons such as, for example, cyclohexane, benzene, toluene or xylene. The transesterification can also be carried out in the absence of solvents.

An enzymatic transesterification is also possible using hydrolases, especially esterases, lipases and proteases as described in the International Publication WO03/074718. The organosilicon group containing photoinitiators are prepared by esterifying or transesterifying of carboxylic acids or carboxylates containing a photolabile functional group with a carbinol terminated organosilicon compound in the presence of an enzyme, which catalyzes the esterification or transesterification reaction.

Enzymes which can be employed are hydrolases, especially esterases, lipases and proteases as described by U.T. Bornscheuer, R. T. Kazlauskas in Hydrolases in Organic Synthesis; Wiley-VCH, 1999, page 65 -195, ISBN 3-527-30104-6.

Specific examples of esterases are those obtained from animals such as horse liver esterase, pig liver esterase, pig pancreas esterase, fungal esterases or esterases from microorganisms such as from Bacillus subtilis or from Pichia polimorpha; Rhizopus sp.-esterases, Penicillium sp.-esterases or yeast esterases or from Candida species, Alcaligene species or Pseudomonas species.

Lipases suitable for use herein include those of animal, plant and microbiological origin. Suitable lipases are also found in many strains of bacteria and fungi.

Specific examples are porcine pancreatic lipase (PPL), (G. candidum (GCL), H.lanuginosa (HLL). Rhizopus sp. (RML, ROL), Candida sp.(CAL-A, CAL-B, CCL), Aspergillus sp.(ANL), Pseudomonas sp. (PCL, PFL)Burholderia sp.(lipase QLM).

Examples of suitable proteolytic enzymes are the subtilisins, thermitase, chymotrypsin, thermolysin, papain, aminoacylasen, penicillin amidases or trypsin. Suitable enzymes are known to those skilled in the art and are not limited to the ones mentioned above.

The enzymes can be employed as crude extracts, in pure form or in immobilized form crude or pure, on a support on which they are bound chemically or physically.

Suitable supports are for example silica gel, diatomite, polyacrylamide, Duolite®, Celite^{®}, Eupergit^{®} (Röhm&Haas, Darmstadt, Deutschland) and the like.

The enzymes can also be employed as cross-linked-enzymes (CLEC's), which enzymes may be obtained from Altus Corp. Suitable enzyme employments are well known and are described, for example, by U.T. Bornscheuer, R. T. Kazlauskas in Hydrolases in Organic Synthesis; Wiley-VCH, 1999, page 61- 64, ISBN 3-527-30104-6, or by K. Faber in Biotransformation in Organic Chemistry, Springer 1997, 3rd Ed., 345 - 357, ISBN 3-540-61688-8; H.-J. Rehm, G. Reed In Biotechnology, VCH 1998, 2nd, Ed. 407 -411.

Preferred are enzymes that are commercially available (Fluka, Sigma, Novo, Amano, Roche etc) or enzymes that are well known and described , for example, by H.-J. Rehm, G. Reed in Biotechnology, VCH 1998, 2nd, Ed. page 40 - 42.

Especially preferred are immobilized lipases, that are thermostable such as Novozyme 435 (recombinante Candida antarctica lipase B (E. M. Anderson et al. Biocat. Biotransf. 1998, 16, 181), (Firma NOVO Nordisk, Bagswaerd, Dänemark)) or the enzyme QLM, QL (Meito Sangyo, Japan).

Enzymes having esterase, lipase and/or protease activity may be obtained from natural sources and/or from microorganism using standard procedures known in the art, for example from cloning processes via expression and amplification.

Thus, the invention relates to a process for preparing the polymeric photoinitiator of the formula I or II as defined in claim 1 by reacting a phenyl glyoxalic acid C₁-C₆alkylester with an OH- or amino terminated organosilicon compound of the formula I' or II' 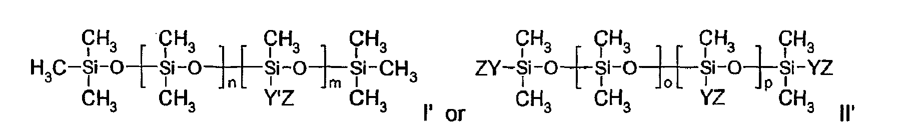 wherein Y and Y' are as defined in claim 1 and Z is OH or NH₂
in the presence of an enzyme which catalyzes the esterification, transesterification or amidation reaction.

The enzymatic esterification or transesterification is carried out at low temperatures especially from 10 to 80°C, preferably from 25-60°C.

The enzymatic esterification, transesterification or amidation can be carried out without adding a solvent or in organic solvents such as for example in hexane, toluene, benzene, THF, diethyl ether, methyl-t.butyl ether, methylene chloride and the like.

The amount of the enzyme catalyst depends on the substrate used and on the reaction conditions such as temperature, reaction time, solvent but may be from 0.01 to 20% by weight, preferably from 1 to 10% by weight based on the modified siloxane employed. The reaction time depends on the amount used and on the activity of the enzyme catalyst, and is, for example, up to 48 hours, preferably up to 24 hours.

In order to maximize the degree of conversion, it is advantageous to remove the water and/or alkanol of reaction, for example by vacuum distillation.

After the end of reaction, the enzyme catalyst can be separated off by means of appropriate measures, such as filtration or decantation, and can, if desired, be used any number of times.

It is advantageous to use immobilized or unsoluble enzymes. Such methods are described in general by W. Tischer et al. TIBTECH 1999, 17, 326; J. Lalonde, Curr. Opin. Drug Disc. & Develop. 1998, 1(3), 271.

It is also possible to carrying out the process continuously in an appropriate reactor. Such processes are described in general in V. M. Balcao et al. Enzyme Microbiol. Techn. 1996, 18, 392; L. Giorno et al. TIBTECH 2000, 18, 339.

Other possibilities of obtaining the compounds of formula I and II are described in the International Publication WO 02/14439.

The compounds of the formula la or IIa are products of Wacker or Degussa siloxanes and can be purchased from Wacker or Degussa.

The compounds of the formula I' or II' may be synthesized by known methods. For example, methods of preparation and/or literature citations for the preparation can be found in the Gelest catalogue "ABCR Gelest 2000", pages 434-447.

The photoinitiator accumulate specifically at the surface of the coating to be cured; in other words, there is a specific orientation of the initiator towards the surface of the formulation.

The invention accordingly also provides a photocurable composition comprising
(A) at least one ethylenically unsaturated free-radically photopolymerizable compound; and
(B) at least one surface-active photoinitiator of the formula I or II;
(C) optionally thermally crosslinkable compounds;
(D) optionally further additives;
(E) optionally further photoinitiators.

The invention further provides a process for producing coatings having scratch-resistant and/or chemical resistant surfaces, in which a photocurable composition as defined above is applied to a substrate; and is cured either only by exposure to electromagnetic radiation with a wavelength ranging from 200 nm into the NIR (near infrared) region or IR region, or by exposure to electromagnetic radiation with a wavelength ranging from 200 nm into the NIR region or IR region and prior, simultaneous and/or subsequent exposure to heat.

### NIR-curing

The NIR radiation used in the process according to the invention is short-wave infrared radiation in the wavelength range from about 750 nm to about 1500 nm, preferably 750 nm to 1200 nm. Radiation sources for NIR radiation include, for example, conventional NIR radiation emitters, which are available commercially (for example, from Adphos).

### IR-curing

The IR radiation used in the process according to the invention is medium wave radiation in the wave length range from about 1500 nm to about 3000 nm and/or longer-wave infra-red radiation in the wave length range above 3000 nm.

IR radiation emitters of this kind are available commercially (for example, from Heraeus).

### UV-curing

The photochemical curing step is carried out usually using light of wavelengths from about 200 nm to about 600 nm, especially from 200 to 450 nm. As light sources there are used a large number of the most varied types. Both point sources and planiform projectors (lamp carpets) are suitable. Examples are: carbon arc lamps, xenon arc lamps, medium-, high-and low-pressure mercury lamps, optionally doped with metal halides (metal halide lamps), LED-lamps, microwave-excited metal-vapor lamps, excimer lamps, super actinic fluorescent tubes, fluorescent lamps, argon filament lamps, electronic flash lamps, photographic flood lights, electron beams and X-rays generated by means of synchrotrons or laser plasma or microwave plasma.

The inventive photoinitiators of the formula I and II can be used in purely photocurable formulations or in photochemically and thermally curable formulations. Thermal curing may take place before, during or after exposure to light.

The invention accordingly also provides a process as described above in which the photocurable formulation comprises as a further component at least one thermally crosslinkable compound (C) and the formulation is cured by exposure to light whose wavelength extends from 200 nm into the NIR region or IR region and by prior, simultaneous and/or subsequent exposure to heat.

In accordance with the invention, the compounds of the formula I or II may be used as surface-active photoinitiators for the photopolymerization of ethylenically unsaturated compounds or mixtures comprising such compounds. The compounds of the formula I or II undergo orientation toward the surface of the respective formulation. In accordance with the invention, the initiators of the formula I or II are not used in compositions which comprise siloxane-modified resin components, since in such compositions the accumulation at the surface is unable to occur; instead, the initiators are compatible with the formulation and are therefore readily miscible.

The invention also provides a method of causing a photoinitiator to accumulate at the surface of coatings comprising ethylenically unsaturated photocurable compounds, which method comprises adding a surface-active photoinitiator of the formula I or II to the photocurable mixture comprising the ethylenically unsaturated photocurable compounds.

**The unsaturated compounds (A)** may contain one or more olefinic double bonds. They may be of low (monomeric) or relatively high (oligomeric) molecular mass. Examples of monomers containing a double bond are alkyl or hydroxyalkyl acrylates or methacrylates, such as methyl, ethyl, butyl, 2-ethylhexyl or 2-hydroxyethyl acrylate, isobornyl acrylate, methyl methacrylate or ethyl methacrylate. Other examples are acrylnitrile, acrylamide, methacrylamide, N-substituted (meth)acrylamides, vinyl esters such as vinyl acetate, vinyl ethers such as isobutyl vinyl ether, styrene, alkylstyrenes and halostyrenes, N-vinylpyrrolidone, vinyl chloride or vinylidene chloride.

Examples of monomers containing two or more double bonds are ethylene glycol, propylene glycol, neopentyl glycol, hexamethylene glycol and bisphenol A diacrylates, 4,4'-bis(2-acry(-oyloxyethoxy)diphenylpropane, trimethylolpropane triacrylate, pentaerythritol triacrylate or tetraacrylate, vinyl acrylate, divinylbenzene, divinyl succinate, diallyl phthalate, triallyl phosphate, triallyl isocyanurate or tris(2-acryloylethyl) isocyanurate.

Examples of relatively high molecular mass (oligomeric) polyunsaturated compounds are acrylated epoxy resin and acrylated or vinyl ether- or epoxy-functional polyesters, polyurethanes and polyethers. Further examples of unsaturated oligomers are unsaturated polyester resins, generally prepared from maleic acid, phthalic acid and one or more diols and having molecular weights of from about 500 to 3000. In addition to these it is also possible to use vinyl ether monomers and oligomers, and also maleate-terminated oligomers with polyesters, polyurethane, polyether, polyvinyl ether and epoxide main chains. Especially suitable are combinations of polymers and oligomers which carry vinyl ether groups, as described in WO 90/01512. Also suitable, however, are copolymers of monomers functionalized with maleic acid and vinyl ether.

Also suitable are compounds containing one or more free-radically polymerizable double bonds. In these compounds the free-radically polymerizable double bonds are preferably in the form of (meth)acryloyl groups. (meth)acryloyl and, respectively, (meth)acrylic here and below means acryloyl and/or methacryloyl, and acrylic and/or methacrylic, respectively. Preferably, at least two polymerizable double bonds are present in the molecule in the form of (meth)acryloyl groups. The compounds in question may comprise, for example, (meth)-acryloyl-functional oligomeric and/or polymeric compounds of poly(meth) acrylate. The number-average molecular mass of this compound may be for example from 300 to 10 000, preferably from 800 to 10 000. The compounds preferably containing free-radically polymerizable double bonds in the form of (meth)acryloyl groups may be obtained by customary methods, for example by reacting poly(meth)acrylates with (meth)acrylic acid. These and other preparation methods are described in the literature and are known to the person skilled in the art.

Unsaturated oligomers of this kind may also be referred to as prepolymers.

Functionalized acrylates are also suitable. Examples of suitable monomers which are normally used to form the backbone (the base polymer) of such functionalized acrylate and methacrylate polymers are acrylate, methyl acrylate, methyl methacrylate, ethyl acrylate, ethyl methacrylate, n-butyl acrylate, n-butyl methacrylate, isobutyl acrylate, isobutyl methacrylate, 2-ethylhexyl acrylate, 2-ethylhexyl methacrylate etc. Additionally, appropriate amounts of functional monomers are copolymerized during the polymerization in order to give the functional polymers. Acid-functionalized acrylate or methacrylate polymers are obtained using acid-functional monomers such as acrylic acid and methacrylic acid. Hydroxy-functional acrylate or methacrylate polymers are formed from hydroxy-functional monomers, such as 2-hydroxyethyl methacrylate, 2-hydroxypropyl methacrylate and 3,4-dihydroxybutyl methacrylate. Epoxy-functionalized acrylate or methacrylate polymers are obtained using epoxy-functional monomers such as glycidyl methacrylate, 2,3-epoxybutyl methacrylate, 3,4-epoxybutyl methacrylate, 2,3-epoxycyclohexyl methacrylate, 10,11-epoxyundecyl methacrylate etc. Similarly, for examle, isocyanate-functionalized polymers may be prepared from isocyanate-functionalized monomers, such as meta-isopropenyl-α,α-dimethylbenzyl isocyanate, for example.

Particularly suitable compounds are, for example, esters of ethylenically unsaturated monofunctional or polyfunctional carboxylic acids and polyols or polyepoxides, and polymers containing ethylenically unsaturated groups in the chain or in side groups, such as unsaturated polyesters, polyamides and polyurethanes and copolymers thereof, alkyd resins, polybutadiene and butadiene copolymers, polyisoprene and isoprene copolymers, polymers and copolymers containing (meth)acrylic groups in side chains, and also mixtures of one or more such polymers.

Examples of suitable monofunctional or polyfunctional unsaturated carboxylic acids are acrylic acid, methacrylic acid, crotonic acid, itaconic acid, cinnamic acid, maleic acid, fumaric acid, unsaturated fatty acids such as linolenic acid or oleic acid. Acrylic acid and methacrylic acid are preferred.

It is, however, also possible to use saturated dicarboxylic or polycarboxylic acids in a mixture with unsaturated carboxylic acids. Examples of suitable saturated dicarboxylic or polycarboxylic acids include tetrachlorophthalic acid, tetrabromophthalic acid, phthalic acid, trimellitic acid, heptanedicarboxylic acid, sebacic acid, dodecanedicarboxylic acid, hexahydrophthalic acid, etc.

Suitable polyols include aromatic and especially aliphatic and cycloaliphatic polyols. Examples of aromatic polyols are hydroquinone, 4,4'-dihydroxybiphenyl, 2,2-di(4-hydroxyphenyl)propane, and also novolaks and resols. Examples of polyepoxides are those based on the aforementioned polyols, especially the aromatic polyols, and epichlorhydrin. Further suitable polyols include polymers and copolymers containing hydroxyl groups in the polymer chain or in side groups, such as polyvinyl alcohol and copolymers thereof or polyhydroxyalkyl methacrylates or copolymers thereof, for example. Oligoesters containing hydroxyl end groups are further suitable polyols.

Examples of aliphatic and cycloaliphatic polyols are alkylenediols having preferably from 2 to 12 carbon atoms, such as ethylene glycol, 1,2- or 1,3-propanediol, 1,2-, 1,3- or 1,4-butanediol, pentanediol, hexanediol, octanediol, dodecanediol, diethylene glycol, triethylene glycol, polyethylene glycols having molecular weights of preferably from 200 to 1500, 1,3-cyclopentanediol, 1,2-, 1,3- or 1,4-cyclohexanediol, 1,4-dihydroxymethylcyclohexane, glycerol, tris(β-hydroxyethyl)amine, trimethylolethane, trimethylolpropane, pentaerythritol, dipentaerythritol and sorbitol.

The polyols may have been partly or fully esterified with one or more different unsaturated carboxylic acids, the free hydroxyl groups in partial esters possibly having been modified, e.g. etherified or esterified with other carboxylic acids.

Examples of esters are:
trimethylolpropane triacrylate, trimethylolethane triacrylate, trimethylolpropane trimethacrylate, trimethylolethane trimethacrylate, tetramethylene glycol dimethacrylate, triethylene glycol dimethacrylate, tetraethylene glycol diacrylate, pentaerythritol diacrylate, pentaerythritol triacrylate, pentaerythritol tetraacrylate, dipentaerythritol diacrylate, dipentaerythritol triacrylate, dipentaerythritol tetraacrylate, dipentaerythritol pentaacrylate, dipentaerythritol hexaacrylate, tripentaerythritol octaacrylate, pentaerythritol dimethacrylate, pentaerythritol trimethacrylate, dipentaerythritol dimethacrylate, dipentaerythritol tetramethacrylate, tripentaerythritol octamethacrylate, pentaerythritol diitaconate, dipentaerythritol trisitaconate, dipentaerythritol pentaitaconate, dipentaerythritol hexaitaconate, ethylene glycol diacrylate, 1,3-butanediol diacrylate, 1,3-butanediol dimethacrylate, 1,4-butanediol diitaconate, sorbitol triacrylate, sorbitol tetraacrylate, modified pentaerythritol triacrylate, sorbitol tetra methacrylate, sorbitol pentaacrylate, sorbitol hexaacrylate, oligoester acrylates and methacrylates, glycerol diacrylate and triacrylate, 1,4-cyclohexane diacrylate, bisacrylates and bismethacrylates of polyethylene glycol having a molecular weight from 200 to 1500, or mixtures thereof.

Suitable components (A) also include the amides of identical or different unsaturated carboxylic acids with aromatic, cycloaliphatic and aliphatic polyamines having preferably from 2 to 6, particularly from 2 to 4 amino groups. Examples of such polyamines are ethylenediamine, 1,2- or 1,3-propylenediamine, 1,2-, 1,3- or 1,4-butylenediamine, 1,5-pentylenediamine, 1,6-hexylenediamine, octylenediamine, dodecylenediamine, 1,4-diaminocyclohexane, isophoronediamine, phenylenediamine, bisphenylenediamine, di-β-aminoethyl ether, diethylenetriamine, triethylenetetramine, di(β-aminoethoxy)- or di(β-aminopropoxy)ethane. Further suitable polyamines are polymers and copolymers containing possibly additional amino groups in the side chain, and oligoamides having amino end groups. Examples of such unsaturated amides are: methylenebisacrylamide, 1,6-hexamethylenebisacrylamide, diethylenetriaminetrismethacrylamide, bis(methacrylamidopropoxy)ethane, β-methacrylamidoethyl methacrylate, and N-[(β-hydroxyethoxy)ethyl]acrylamide.

Suitable unsaturated polyesters and polyamides are derived, for example, from maleic acid and diols or diamines. The maleic acid may have been replaced in part by other dicarboxylic acids. They may be used together with ethylenically unsaturated comonomers, e.g. styrene. The polyesters and polyamides may also be derived from dicarboxylic acids and ethylenically unsaturated diols or diamines, especially from relatively long chain ones having, for example, from 6 to 20 carbon atoms. Examples of polyurethanes are those synthesized from saturated or unsaturated diisocyanates and unsaturated or saturated diols, respectively.

Polybutadiene and polyisoprene and copolymers thereof are known. Examples of suitable comonomers are olefins such as ethylene, propene, butene, hexene, (meth)acrylates, acrylonitrile, styrene or vinyl chloride. Polymers containg (meth)acrylate groups in the side chain are likewise known. They may comprise, for example, reaction products of novolak-based epoxy resins with (meth)acrylic acid, homopolymers or copolymers of vinyl alcohol or the hydroxyalkyl derivatives thereof that have been esterified with (meth)acrylic acid, or homopolymers and copolymers of (meth)acrylates esterified with hydroxyalkyl (meth)-acrylates.

The photopolymerizable compounds (A) may be used alone or in any desired mixtures. Preference is given to using mixtures of polyol (meth)acrylates.

It is also possible to add binders to the compositions of the invention, which is especially appropriate when the photopolymerizable compounds are liquid or viscous substances. The amount of the binder can be for example 5-95, preferably 10-90 and especially 40-90% by weight, based on the overall solids. The choice of binder is made depending on the field of use and the properties required for that field, such as developability in aqueous and organic solvent systems, adhesion to substrates, and oxygen sensitivity, for example.

The unsaturated compounds may also be used in a mixture with non-photopolymerizable film-forming components. These may be, for example, physically drying polymers or their solutions in organic solvents, such as nitrocellulose or cellulose acetobutyrate, for example. They may also, however, be chemically and/or thermally curable resins, such as polyisocyanates, polyepoxides or melamine resins, for example. By melamine resins are meant not only condensates of melamine (1,3,5-triazine-2,4,6-triamine) but also those of melamine derivatives. In general, the components comprise a film-forming binder based on a thermoplastic or thermosettable resin, predominantly on a thermosettable resin. Examples thereof are alkyd, acrylic, polyester, phenolic, melamine, epoxy and polyurethane resins and mixtures thereof. The additional use of thermally curable resins is of importance for use in what are known as hybrid systems, which may be both photopolymerized and also thermally crosslinked.

Component (A) may comprise, for example, a coating composition comprising
(A1) compounds containing one or more free-radically polymerizable double bonds and further containing at least one other functional group which is reactive in the sense of an addition reaction and/or condensation reaction (examples have been given above),
(A2) compounds containing one or more free-radically polymerizable double bonds and further containing at least one other functional group which is reactive in a sense of an addition reaction and/or condensation reaction, the additional reactive functional group being complementary to or reactive toward the additional reactive functional groups of component (A1),
(A3) if desired, at least one monomeric, oligomeric and/or polymeric compound containing at least one functional group which is reactive in the sense of an addition reaction and/or condensation reaction toward the functional groups from component (A1) or component (A2) that are present in addition to the free-radically polymerizable double bonds.

Component (A2) carries in each case the groups which are reactive toward or complementary to component (A1). In this context it is possible in each case for different kinds of functional groups to be present in one component. In component (A3) there is a further component available containing functional groups which are reactive in the sense of addition reactions and/or condensation reactions and which are able to react with the functional groups of (A1) or (A2) that are present in addition to the free-radically polymerizable double bonds. Component (A3) contains no free-radically polymerizable double bonds. Examples of such combinations of (A1), (A2), (A3) can be found in WO 99/55785. Examples of suitable reactive functional groups are selected, for example, from hydroxyl, isocyanate, epoxide, anhydride, carboxyl, thiols or blocked amino groups. Examples have been described above.

Constituents of component (C) are, for example, thermally curable coating system constituents that are customary in the art. Accordingly, component (C) may comprise two or more constituents.

Examples of component (C) are oligomers and/or polymers derived from α,β-unsaturated acids and derivatives thereof; examples are polyacrylates and polymethacrylates, and polyacrylonitriles, polyacrylamides and polymethyl methacrylates that have been impact-modified using butyl acrylate. Further examples of component (C) are urethanes, polyurethanes derived from polyethers, polyesters and polyacrylates containing free hydroxyl groups or thiol groups, on the one hand, and aliphatic or aromatic polyisocyanates, on the other, and also precursors thereof. Accordingly, component (C) also comprises, for example, crosslinkable acrylic resins derived from substituted acrylates, such as epoxy acrylates, urethane acrylates or polyester acrylates. It is also possible for alkyd resins, polyester resins and acrylic resins and their modifications, which are crosslinked with melamine resins, urea resins, isocyanates, isocyanurates, polyisocyanates, polyisocyanurates and epoxy resins, to be constituents of component (C).

Component (C) generally comprises for example, a film-forming binder based on a thermoplastic or thermosettable resin, predominantly on a thermosettable resin. Examples thereof are alkyd, acrylic, polyester, phenolic, melamine, epoxy and polyurethane resins and mixtures thereof. Examples of these are described, for example, in Ullmann's Encyclopedia of Industrial Chemistry, 5th Ed., Vol. A18, pp. 368-426, VCH, Weinheim 1991.

Component (C) may be a cold-curable or heat-curable binder, and the addition of a curing catalyst may be advantageous. Suitable catalysts that accelerate the curing of the binder are described, for example, in Ullmann's Encyclopedia of Industrial Chemistry, Vol. A18, p.469, VCH Verlagsgesellschaft, Weinheim 1991.

Examples of specific binders suitable as component (C) are
1. Paints based on cold- or heat-crosslinkable alkyd, acrylate, polyester, epoxy or melamine resins or mixtures of such resins, with or without addition of a curing catalyst;
2. Two-component polyurethane paints based on hydroxyl-containing acrylate, polyester or polyether resins and on aliphatic or aromatic isocyanates, isocyanurates or polyisocyanates;
3. One-component polyurethane paints based on blocked isocyanates, isocyanurates or polyisocyanates that are deblocked in the course of stoving; melamine resins can also be added, if appropriate;
4. One-component polyurethane paints based on aliphatic or aromatic urethanes or polyurethanes and on hydroxyl-containing acrylate, polyester or polyether resins;
5. One-component polyurethane paints based on aliphatic or aromatic urethane acrylates or polyurethane acrylates having free amine groups in the urethane structure and on melamine resins or polyether resins, with or without addition of a curing catalyst;
6. Two-component paints based on (poly)ketimines and on aliphatic or aromatic isocyanates, isocyanurates or polyisocyanates;
7. Two-component paints based on (poly)ketimines and on an unsaturated acrylate resin or a polyacetoacetate resin or a methacrylamidoglycolate methyl ester;
8. Two-component paints based on carboxyl- or amino-containing polyacrylates and polyepoxides;
9. Two-component paints based on acrylate resins containing anhydride groups and on a polyhydroxy or polyamino component;
10. Two-component paints based on acrylate-containing anhydrides and polyepoxides;
11. Two-component paints based on (poly)oxazolines and on acrylate resins containing anhydride groups, or unsaturated acrylate resins or aliphatic or aromatic isocyanates, isocyanurates or polyisocyanates;
12. Two-component paints based on unsaturated polyacrylates and polymalonates;
13. Thermoplastic polyacrylate paints based on thermoplastic acrylate resins or externally crosslinking acrylate resins in combination with etherified melamine resins;
14. Paint systems based on urethane (meth)acrylate containing (meth)acryloyl groups and free isocyanate groups and on one or more isocyanate-reactive compounds, such as unesterified or esterified polyols. Such systems are published, for example, in EP 928800.

Blocked isocyanates as may be employed, inter alia, in component (C) are described, for example, in Organischer Metallschutz: Entwicklung und Anwendung von Beschichtungsstoffen [Organic Protection of Metals: Development and Application of Coating Materials], page 159-160, Vincentz Verlag, Hannover (1993). These are compounds in which the highly reactive NCO group is "blocked" by reaction with specific radicals, such as primary alcohols, phenol, acetoacetates, ε-caprolactam, phthalimide, imidazole, oxime or amine. The blocked isocyanate is stable in liquid systems and also in the presence of hydroxyl groups. On heating, the blocking agents are eliminated and the NCO group is exposed.

Both 1-component (1K) and 2-component (2K) systems may be used as component (C). Examples of such systems are described in Ullmann's Encyclopedia of Industrial Chemistry, Vol. A18, Paints and Coatings, page 404-407, VCH Verlagsgesellschaft mbH, Weinheim (1991).

The composition may be optimized by specially adapting the formulation, for example by varying the binder/crosslinker ratio. Such measures are well known to the person skilled in the art of coatings technology.

In the curing process of the invention the component (C) is preferably a mixture based on acrylate/melamine (and melamine derivatives), 2-component polyurethane, 1-component polyurethane, 2-component epoxy/carboxy or 1-component epoxy/carboxy. Mixtures of these systems are also possible, an example being the addition of melamine (or derivatives thereof) to 1-component polyurethanes.

Component (C) is preferably a binder based on a polyacrylate with melamine or on a melamine derivative. Preference is also given to a system based on a polyacrylate polyol and/or polyester polyol with an unblocked polyisocyanate or polyisocyanurate.

Component (C) may further comprise monomeric and/or oligomeric compounds containing ethylenically unsaturated bonds (prepolymers) which additionally contain at least one or more OH, SH, NH₂, COOH, epoxy or NCO groups (= C1) capable of reaction with the binder and/or crosslinker substituent of component (C). Following application and thermal curing, the ethylenically unsaturated bonds are converted by UV radiation into a crosslinked, high molecular mass form. Examples of such components (C) are described, for example, in the abovementioned publication Ullmann's Encyclopedia of Industrial Chemistry, 5th Ed., Vol. A18, pages 451-453, or by S. Urano, K. Aoki, N. Tsuboniva and R. Mizuguchi in Progress in Organic Coatings, 20 (1992), 471-486, or by H. Terashima and O. Isozaki in JOCCA 1992 (6), 222. (C1) may be, for example, an OH-containing unsaturated acrylate, e.g. hydroxyethyl or hydroxybutyl acrylate or else glycidyl acrylates. The component (C1) may be of any desired construction (e.g. polyester, polyacrylate, polyether, etc., units) provided there are an ethylenically unsaturated double bond and also free OH, COOH, NH₂, epoxy or NCO groups.

(C1) may also be obtained, for example, by reacting an epoxy-functional oligomer with acrylic acid or methacrylic acid. A typical example of an OH-functional oligomer containing vinylic double bonds is 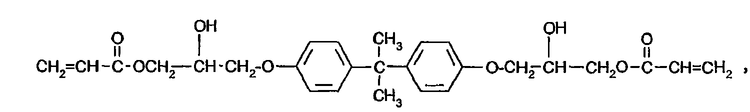 obtained by
reacting

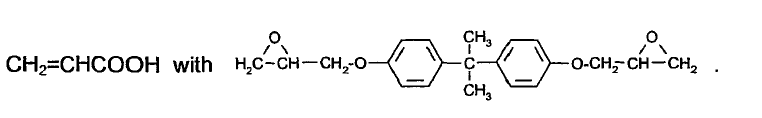

One possibility for preparing component (C1) is also, for example, the reaction of an oligomer that contains only one epoxy group and at another site in the molecule possesses a free OH group.

The ratio of components (A) to (C) in the UV-crosslinking and thermally crosslinking formulations is not critical. "Dual-cure" systems are well known to the person skilled in the art, who is therefore well aware of the optimum proportions of the UV-crosslinkable and thermally crosslinkable components for the particular desired application. For example, the compositions may comprise components (A) and (C) in a ratio of from 5:95 to 95:5, from 20:80 to 80:20 or from 30:70 to 70:30, e.g. from 40:60 to 60:40.

Examples of "dual-cure" systems, i.e. systems containing both UV-curable and thermally curable components, may be found, inter alia, in US 5,922,473, columns 6 to 10.

To the compositions that are used in the process of the invention it is also possible to add solvents or water. Where the compositions are used without solvents, they comprise, for example, powder coating formulations. Suitable solvents are solvents which are known to the person skilled in the art and are customary particularly in coatings technology. Examples are various organic solvents, such as ketones, e.g. methyl ethyl ketone, cyclohexanone; aromatic hydrocarbons, e.g. toluene, xylene or tetramethylbenzene; glycol ethers, such as diethylene glycol monoethyl ether, dipropylene glycol diethyl ether; esters, such as ethyl acetate; aliphatic hydrocarbons, such as hexane, octane, decane; or petroleum solvents, such as petroleum ether.

The invention also provides compositions comprising as component (A) at least one ethylenically unsaturated photopolymerizable compound in emulsion or solution in water. Such radiation-curable aqueous prepolymer dispersions are available commercially in numerous variations. They are understood to comprise a dispersion of water and at least one prepolymer dispersed therein. The concentration of the water in these systems is, for example, from 5 to 80, in particular from 30 to 60% by weight. The radiation-curable prepolymer or prepolymer mixture is present, for example, in concentrations of from 95 to 20, in particular from 70 to 40% by weight. In these compositions the sum of the percentages stated for water and prepolymers is in each case 100; the auxiliaries and additives are extra in different amounts depending on the intended use.

The radiation-curable film-forming prepolymers which are in dispersion and often also in solution in water comprise monofunctional or polyfunctional ethylenically unsaturated prepolymers which are known per se for aqueous prepolymer dispersions, may be initiated by means of free radicals, and have a polymerizable double bond content of, for example, from 0.01 to 1.0 mol per 100 g of prepolymer and also have an average molecular weight of, for example, at least 400, in particular from 500 to 10 000. Depending on the intended application, however, prepolymers with higher molecular weights may also be suitable. Use is made, for example, of polyesters containing polymerizable C-C double bonds and having an acid number of not more than 10, polyethers containing polymerizable C-C double bonds, hydroxyl-containing reaction products of a polyepoxide containing at least two epoxide groups per molecule with at least one α,β-ethylenically unsaturated carboxylic acid, polyurethane (meth)acrylates, and also acrylic copolymers containing α,β-ethylenically unsaturated acrylic radicals, as described, for example, in EP 012339. Mixtures of these prepolymers may likewise be used. Examples of further suitable prepolymers include the polymerizable prepolymers described in EP 033896, which are thioether adducts of polymerizable prepolymers having an average molecular weight of at least 600, a carboxyl group content of from 0.2 to 15% and a polymerizable C-C double bond content of from 0.01 to 0.8 mol per 100 g of prepolymer. Other suitable aqueous dispersions based on specific alkyl (meth)acrylate polymers are described in EP 041125; suitable water-dispersible, radiation-curable prepolymers comprising urethane acrylates are given, for example, in DE 2936039.

As further additions, these radiation-curable aqueous prepolymer dispersions may comprise dispersing aids, emulsifiers, antioxidants, light stabilizers, dyes, pigments, fillers, e.g. talc, gypsum, silica, rutile, carbon black, zinc oxide, iron oxides, reaction accelerants, levelling agents, lubricants, wetting agents, thickeners, matting agents, defoamers, and other auxiliaries customary in coatings technology. Suitable dispersing aids include water-soluble organic compounds of high molecular mass containing polar groups, such as polyvinyl alcohols, polyvinylpyrrolidone or cellulose ethers. Emulsifiers which can be used include nonionic, and possibly also ionic, emulsifiers.

The compounds of the invention and mixtures thereof may also be used as free-radical photoinitiators or photoinitiating systems for radiation-curable powder coating or powder slurry materials. The powder coating materials may be based on solid resins and monomers containing reactive double bonds, such as maleates, vinyl ethers, acrylates, acrylamides and mixtures thereof. A free-radically UV-curable powder coating material may be formulated by mixing unsaturated polyester resins with solid acrylamides (e.g. methylacrylamidoglycolate methyl ester) and a free-radical photoinitiator of the invention, as described for example in the paper "Radiation Curing of Powder Coating", Conference Proceedings, Radtech Europe 1993 by M. Wittig and Th. Gohmann. Free-radically UV-curable powder coating materials may also be formulated by mixing unsaturated polyester resins with solid acrylates, methacrylates or vinyl ethers and a photoinitiator (or photoinitiator mixture) of the invention. The powder coating materials may also include binders, as described for example in DE 4228514 and EP 636669. The powder coating formulations described in EP 636669 contain, for example, a) an unsaturated resin from the group of the (semi)crystalline or amorphous unsaturated polyesters, unsaturated polyacrylates or mixtures thereof with unsaturated polyesters, particular preference being given to those derived from maleic acid or fumaric acid; b) an oligomeric or polymeric crosslinking agent containing vinyl ether-functional, vinyl ester-functional or (meth)acrylate-functional groups, particular preference being given to vinyl ether oligomers, such as divinyl ether-functionalized urethanes; c) the photoinitiator.

The UV-curable powder coating materials may also comprise white or coloured pigments. For example, preferably rutile titanium dioxide may be used in concentrations of up to 50% by weight in order to give a cured powder coating possessing good hiding power. The technique normally involves applying the powder to the substrate, such as metal or wood, by electrostatic or tribostatic spraying, melting the powder by heating and, after a smooth film has formed, radiation-curing the coating with ultraviolet and/or visible light, using medium-pressure mercury lamps, metal halide lamps or xenon lamps, for example. A particular advantage of the radiation-curable powder coating materials over their thermally curable counterparts is that the flow time after melting of the powder particles may be selectively extended in order to ensure the formation of a smooth, highly glossy coating. Unlike thermally curable systems, radiation-curable powder coating materials may be formulated without the unwanted effect of a shortened lifetime in such a way that they melt at relatively low temperatures. For this reason they are also suitable as coatings for heat-sensitive substrates, such as wood or plastics.

Where the powder coating materials are not to be applied to heat-sensitive substrates, as in the case of metals (vehicle coatings), however, it is also possible to provide dual-cure powder coating formulations with the photoinitiators of the invention. The person skilled in the art knows such formulations; they are cured both thermally and by means of UV. Formulations of this kind are given, for example, in US 5,922,473.

Besides the photoinitiators of the invention, the powder coating formulations may also comprise UV absorbers. Appropriate examples are listed later on below.

Besides the photoinitiator, the photopolymerizable mixtures may comprise various additives (D). Examples of these are thermal inhibitors, which are intended to prevent premature polymerization, such as hydroquinone, hydroquinone derivatives, p-methoxyphenol, β-naphthol or sterically hindered phenols such as 2,6-di(tert-butyl)-p-cresol. To increase the dark storage stability it is possible to use copper compounds, such as copper naphthenate, copper stearate or copper octoate, phosphorus compounds, such as triphenylphosphine, tributylphosphine, triethyl phosphite, triphenyl phosphite or tribenzyl phosphite, quaternary ammonium compounds, such as tetramethylammonium chloride or trimethylbenzylammonium chloride, or hydroxylamine derivatives, such as N-diethylhydroxylamine, for example. For the purpose of excluding atmospheric oxygen in the course of the polymerization it is possible to add paraffin or similar wax-like substances, which at the beginning of polymerization migrate to the surface, on account of their poor solubility in the polymer, where they form a transparent surface layer which prevents the ingress of air. Similarly, it is possible to apply an oxygen-impermeable layer. Light stabilizers which can be added include UV absorbers, such as those of the hydroxyphenylbenzotriazole, hydroxyphenylbenzophenone, oxalmide or hydroxyphenyl-s-triazine type. These compounds may be used individually or in mixtures, with or without the use of sterically hindered amines (HALS).

Examples of such UV absorbers and light stabilizers are
1. 2-(2'-Hydroxyphenyl)benzotriazoles, for example 2-(2'-hydroxy-5'-methylphenyl)-benzotriazole, 2-(3',5'-di-tert-butyl-2'-hydroxyphenyl)benzotriazole, 2-(5'-tert-butyl-2'-hydroxyphenyl)benzotriazole, 2-(2'-hydroxy-5'-(1,1,3,3-tetramethylbutyl)phenyl)benzotriazole, 2-(3',5'-di-tert-butyl-2'-hydroxyphenyl)-5-chloro-benzotriazole, 2-(3'-tert-butyl- 2'-hydroxy-5'-methylphenyl)-5-chloro-benzotriazole, 2-(3'-sec-butyl-5'-tert-butyl-2'-hydroxyphenyl)-benzotriazole, 2-(2'-hydroxy-4'-octyloxyphenyl)benzotriazole, 2-(3',5'-di-tert-amyl-2'-hydroxyphenyl)benzotriazole, 2-(3',5'-bis-(α,α-dimethylbenzyl)-2'-hydroxyphenyl)-benzotriazole, 2-(3'-tert-butyl-2'-hydroxy-5'-(2-octyloxycarbonylethyl)phenyl)-5-chlorobenzotriazole, 2-(3'-tert-butyl-5'-[2-(2-ethylhexyloxy)-carbonylethyl]-2'-hydroxyphenyl)-5-chloro-benzotriazole, 2-(3'-tert-butyl-2'-hydroxy-5'-(2-methoxycarbonylethyl)phenyl)-5-chloro-benzotriazole, 2-(3'-tert-butyl-2'-hydroxy-5'-(2-methoxycarbonylethyl)phenyl)-benzotriazole, 2-(3'-tert-butyl-2'-hydroxy-5'-(2-octyloxycarbonylethyl)phenyl)benzotriazole, 2-(3'-tert-butyl-5'-[2-(2-ethylhexyloxy)carbonylethyl]-2'-hydroxyphenyl)benzotriazole, 2-(3'-dodecyl-2'-hydroxy-5'-methylphenyl)benzotriazole, 2-(3'-tert-butyl-2'-hydroxy-5'-(2-isooctyloxycarbonylethyl)phenylbenzotriazole, 2,2'-methylene-bis[4-(1,1,3,3-tetramethylbutyl)-6-benzotriazol-2-ylphenol]; the transesterification product of 2-[3'-tert-butyl-5'-(2-methoxycarbonylethyl)-2'-hydroxyphenyl]-2H-benzotriazole with polyethylene glycol 300; [R-CH₂CH₂-COO-CH₂CH₂]₂- where R = 3'-tert-butyl-4'-hydroxy-5'-2H-benzotriazol-2-ylphenyl, 2-[2'-hydroxy-3'-(α,α-dimethylbenzyl)-5'-(1,1,3,3-tetramethylbutyl)-phenyl]benzotriazole; 2-[2'-hydroxy-3'-(1,1,3,3-tetramethylbutyl)-5'-(α,α-dimethylbenzyl)-phenyl]benzotriazole.
2. 2-Hydroxybenzophenones, for example the 4-hydroxy, 4-methoxy, 4-octyloxy, 4-decyloxy, 4-dodecyloxy, 4-benzyloxy, 4,2',4'-trihydroxy and 2'-hydroxy-4,4'-dimethoxy derivatives.
3. Esters of substituted and unsubstituted benzoic acids, for example 4-tert-butyl-phenyl salicylate, phenyl salicylate, octylphenyl salicylate, dibenzoyl resorcinol, bis(4-tert-butylbenzoyl) resorcinol, benzoyl resorcinol, 2,4-di-tert-butylphenyl 3,5-di-tert-butyl-4-hydroxybenzoate, hexadecyl 3,5-di-tert-butyl-4-hydroxybenzoate, octadecyl 3,5-di-tert-butyl-4-hydroxybenzoate, 2-methyl-4,6-di-tert-butylphenyl 3,5-di-tert-butyl-4-hydroxybenzoate.
4. Acrylates, for example ethyl α-cyano-β,β-diphenylacrylate, isooctyl α-cyano-β,β-diphenylacrylate, methyl α-carbomethoxycinnamate, methyl α-cyano-β-methyl-p-methoxycinnamate, butyl α-cyano-β-methyl-p-methoxy-cinnamate, methyl α-carbomethoxy-p-methoxycinnamate and N-(β-carbomethoxy-β-cyanovinyl)-2-methylindoline.
5. Sterically hindered amines, for example bis(2,2,6,6-tetramethyl-4-piperidyl) sebacate, bis(2,2,6,6-tetramethyl-4-piperidyl) succinate, bis(1,2,2,6,6-pentamethyl-4-piperidyl) sebacate, bis(1-octyloxy-2,2,6,6-tetramethyl-4-piperidyl) sebacate, bis(1,2,2,6,6-pentamethyl-4-piperidyl) n-butyl-3,5-di-tert-butyl-4-hydroxybenzylmalonate, the condensate of 1-(2-hydroxyethyl)-2,2,6,6-tetramethyl-4-hydroxypiperidine and succinic acid, linear or cyclic condensates of N,N'-bis(2,2,6,6-tetramethyl-4-piperidyl)hexamethylenediamine and 4-tert-octylamino-2,6-dichloro-1,3,5-triazine, tris(2,2,6,6-tetramethyl-4-piperidyl) nitrilotriacetate, tetrakis(2,2,6,6-tetramethyl-4-piperidyl) 1,2,3,4-butane-tetracarboxylate, 1,1'-(1,2-ethanediyl)-bis(3,3,5,5-tetramethylpiperazinone), 4-benzoyl-2,2,6,6-tetramethylpiperidine, 4-stearyloxy-2,2,6,6-tetramethylpiperidine, bis(1,2,2,6,6-pentamethylpiperidyl) 2-n-butyl-2-(2-hydroxy-3,5-di-tert-butylbenzyl)malonate, 3-n-octyl-7,7,9,9-tetramethyl-1,3,8-triazaspiro[4.5]decane-2,4-dione, bis(1-octyloxy-2,2,6,6-tetramethylpiperidyl) sebacate, bis(1-octyloxy-2,2,6,6-tetramethylpiperidyl) succinate, linear or cyclic condensates of N,N'-bis-(2,2,6,6-tetramethyl-4-piperidyl)hexamethylenediamine and 4-morpholino-2,6-dichloro-1,3,5-triazine, the condensate of 2-chloro-4,6-bis(4-n-butylamino-2,2,6,6-tetramethylpiperidyl )-1,3,5-triazine and 1,2-bis(3-aminopropylamino)-ethane, Tinuvin 152 (2,4-bis[N-butyl-N-(1-cyclohexyloxy-2,2,6,6-tetramethylpiperidin-4yl)amino]-6-(2-hydroxyethylamine)-1,3,5-triazine) the condensate of 2-chloro-4,6-di-(4-n-butylamino-1,2,2,6,6-pentamethylpiperidyl)-1,3,5-triazine and 1,2-bis-(3-aminopropylamino)ethane, 8-acetyl-3-dodecyl-7,7,9,9-tetramethyl-1,3,8-triazaspiro[4.5]decane-2,4-dione, 3-dodecyl-1-(2,2,6,6-tetramethyl-4-piperidyl)pyrrolidine-2,5-dione, 3-dodecyl-1-(1,2,2,6,6-pentamethyl-4-piperidyl)pyrrolidine-2,5-dione, a mixture of 4-hexadecyloxy- and 4-stearyloxy-2,2,6,6-tetramethylpiperidine, a condensation product of N,N'-bis(2,2,6,6-tetramethyl-4-piperidyl)hexamethylenediamine and 4-cyclohexylamino-2,6-dichloro-1,3,5-triazine, a condensation product of 1,2-bis(3-aminopropylamino)ethane and 2,4,6-trichloro-1,3,5-triazine as well as 4-butylamino-2,2,6,6-tetramethylpiperidine (CAS Reg. No. [136504-96-6]); N-(2,2,6,6-tetramethyl-4-piperidyl)-n-dodecylsuccinimide, N-(1,2,2,6,6-pentamethyl-4-pipefidyl)-n-dodecyl-succinimide, 2-undecyl-7,7,9,9-tetramethyl-1-oxa-3,8-diaza-4-oxo-spiro[4.5]decane, a reaction product of 7,7,9,9-tetramethyl-2-cycloundecyl-1-oxa-3,8-diaza-4-oxospiro [4.5]decane and epichlorohydrine, 1,1-bis(1,2,2,6,6-pentamethyl-4-piperidyloxycarbonyl)-2-(4-methoxyphenyl)ethene, N,N'-bis-formyl-N,N'-bis(2,2,6,6-tetramethyl-4-piperidyl)-hexamethylenediamine, diester of 4-methoxy-methylene-malonic acid with 1,2,2,6,6-pentamethyl-4.-hydroxypiperidine, poly[methylpropyl-3-oxy-4-(2,2,6,6-tetramethyl-4-piperidyl)]siloxane, reaction product of maleic acid anhydride-α-olefin-copolymer with 2,2,6,6-tetramethyl-4-aminopiperidine or 1,2,2,6,6-pentamethyl-4.-aminopiperidine.
6. Oxamides, for example 4,4'-dioctyloxyoxanilide, 2,2'-diethoxyoxanilide, 2,2'-dioctyloxy-5,5'-di-tert-butoxanilide, 2,2'-didodecyloxy-5,5'-di-tert-butoxanilide, 2-ethoxy-2'-ethyloxanilide, N,N'-bis(3-dimethylaminopropyl)oxamide, 2-ethoxy-5-tert-butyl-2'-ethoxanilide and its mixture with 2-ethoxy-2'-ethyl-5,4'-di-tert-butoxanilide, mixtures of o- and p-methoxy-disubstituted oxanilides and mixtures of o- and p-ethoxy-disubstituted oxanilides.
7. 2-(2-Hydroxyphenyl)-1,3,5-triazines, for example 2,4-Bis(4-phenylphenyl)-6-(2-hydroxy-4-[1-octyloxycarbonylethoxy])- 1,3,5-triazin; 2,4,6-tris(2-hydroxy-4.-octyloxyphenyl)-1,3,5-triazine, 2-(2-hydroxy-4-octyloxyphenyl)-4,6-bis(2,4-dimethylphenyl)-1,3,5-triazine, 2-(2,4-dihydroxyphenyl)-4,6-bis(2,4-dimethylphenyl)-1,3,5-triazine, 2,4-bis(2-hydroxy-4-propyloxyphenyl)-6-(2,4-dimethylphenyl)-1,3,5-triazine, 2-(2-hydroxy-4-octyloxyphenyl)-4,6-bis-(4-methylphenyl)-1,3,5-triazine, 2-(2-hydroxy-4-dodecyloxyphenyl)-4,6-bis(2,4-dimethylphenyl)-1,3,5-triazine, 2-(2-hydroxy-4-tridecyloxyphenyl)-4,6-bis(2,4-dimethylphenyl) 1,3,5-triazine, 2-[2-hydroxy-4-(2-hydroxy-3-butyloxy-propoxy)phenyl]-4,6-bis(2,4-dimethyl)-1,3,5-triazine, 2-[2-hydroxy-4-(2-hydroxy-3-octyloxy-propyloxy)phenyl]-4,6-bis(2,4-dimethyl)-1,3,5-triazine, 2-[4-(dodecyloxy/tridecyloxy-2-hydroxypropoxy)-2-hydroxyphenyl]-4,6-bis(2,4-dimethylphenyl)-1,3,5-triazine, 2-[2-hydroxy-4-(2-hydroxy-3-dodecyloxy-propoxy)phenyl]-4,6-bis(2,4-dimethylphenyl)-1,3,5-triazine, 2-(2-hydroxy-4-hexyloxy)phenyl-4,6-diphenyl-1,3,5-triazine, 2-(2-hydroxy-4-methoxyphenyl)-4,6-diphenyl-1,3,5-triazine, 2,4,6-tris[2-hydroxy-4-(3-butoxy-2-hydroxy-propoxy)phenyl]-1,3,5-triazine, 2-(2-hydroxyphenyl)-4-(4-methoxyphenyl)-6-phenyl-1,3,5-triazine, 2-{2-hydroxy-4-[3-(2-ethythexyl-oxy)-2-hydroxypropyloxy]phenyl}-4,6-bis(2,4-dimethylphenyl)-1,3,5-triazine.
8. Phosphites and phosphonites, for example triphenyl phosphite, diphenyl alkyl phosphites, phenyl dialkyl phosphites, tris(nonylphenyl) phosphite, trilauryl phosphite, trioctadecyl phosphite, distearyl pentaerythritol diphosphite, tris(2,4-di-tert-butylphenyl) phosphite, diisodecyl pentaerythritol diphosphite, bis(2,4-di-tert-butylphenyl) pentaerythritol diphosphite, bis(2,6-di-tert-butyl-4.-methylphenyl) pentaerythritol diphosphite, diisodecyloxypentaerythritol diphosphite, bis(2,4-di-tert-butyl-6-methylphenyl) pentaerythritol diphosphite, bis(2,4,6-tris(tert-butyl) phenyl pentaerythritol diphosphite, tristearyl sorbitol triphosphite, tetrakis(2,4-di-tert-butylphenyl) 4,4'-biphenylene diphosphonite, 6-isooctyloxy-2,4,8,10-tetra-tert-butyl-12H-dibenzo[d,g]-1,3,2-dioxaphosphocin, bis(2,4-di-tert-butyl-6-methylphenyl) methyl phosphite, bis(2,4-di-tert-butyl-6-methylphenyl) ethyl phosphite, 6-fluoro-2,4,8,10-tetra-tert-butyt-12-methyl-dibenzo[d,g]-1,3,2-dioxaphosphocin, 2,2',2"-nitrilo[triethyl tris(3,3',5,5'-tetra-tert-butyl-1,1'-biphenyl-2,2'-diyl)phosphite], 2-ethylhexyl(3,3',5,5'-tetra-tert-butyl-1,1'-biphenyl-2,2'-diyl )phosphite, 5-butyl-5-ethyl-2-(2,4,6-tri-tert-butylphenoxy)-1,3,2-dioxaphosphirane.

Furthermore, it is possible to use additives customary in the art, such as antistatics, flow improvers and adhesion promoters.

Owing to the surface activity of the compounds of the invention it is also possible to use these compounds as flow improvers, either alone or in combination with further customary flow improvers.

The invention further provides for the use of compounds of the formula I or II as flow improvers, alone or in combination with further, customary flow improvers.

DIN 55945 defines leveling as "the more or less pronounced capacity of a still-liquid coating itself to compensate the unevenness which arise in the course of its application" (cf. J. Bieleman, Lackadditive [Additives for Coatings], VCH Weinheim 1998, chapter 6). The leveling of a coating material depends greatly on its flow behaviour and on its surface tension. Flow improvers are substances which help wet coatings to become films which flow out evenly, by reducing the viscosity and/or surface tension. In the case of powder coating materials, flow improvers also lower the melt viscosity and the glass transition temperature and have an additional devolatilizing effect. Flow improvers are used to eliminate leveling defects or surface defects which detract from the overall appearance of the coating. Leveling defects or surface defects include the orange peel effect, formation of structures, cratering, fisheyes, sensitivity to draughts, substrate wetting problems, brush marks, runs, bittiness, pinholes, etc. The use of the compounds of the invention as flow improvers makes it possible to lower the surface tension. The surface tension may be calculated by determining the marginal angle of a drop of liquid on a surface (contact angle measurement).

In order to accelerate the photopolymerization it is possible to add, as further additives (D), amines, such as triethanolamine, N-methyldiethanolamine, ethyl p-dimethylaminobenzoate, or Michler's ketone. The effect of the amines may be boosted by adding aromatic ketones of the benzophenone type. Examples of amines which can be used as oxygen scavengers are substituted N,N-dialkylanilines, as described in EP-A 339841. Further accelerators, coinitiators and autoxidizers are thiols, thioethers, disulfides and phosphines, as described for example in EP 438123 and GB 2180358.

It is also possible to add chain transfer reagents customary in the art to the compositions of the invention. Examples are mercaptans, amines and benzothiazole.

The photopolymerization may further be accelerated by adding photosensitizers as further additives (D), which shift or broaden the spectral sensitivity. These photosensitizers are, in particular, aromatic carbonyl compounds such as benzophenone derivatives, thioxanthone derivatives, and also especially isopropylthioxanthone, anthraquinone derivatives and 3-acylcoumarin derivatives, terphenyls, styryl ketones, and also 3-(aroylmethylene)-thiazolines, camphorquinone, and also eosine dyes, rhodamine dyes and erythrosine dyes.

The amines indicated above, for example, may also be regarded as photosensitizers.

The curing process, especially of compositions which are pigmented (with titanium dioxide for example), may also be assisted by adding an additional additive (D) which is a component which under thermal conditions forms free radicals, such as an azo compound, for instance 2,2'-azobis(4-methoxy-2,4-dimethylvaleronitrile), a triazene, diazo sulfide, pentazadiene or a peroxy compound such as hydroperoxide or peroxycarbonate, e.g. t-butyl hydroperoxide, as described for example in EP 245639.

As further additives (D), the compositions may also comprise, for example, a photoreducible dye, such as xanthene, benzoxanthene, benzothioxanthene, thiazine, pyronine, porphyrin or acridine dyes, and/or a radiation-cleavable trihalomethyl compound. Similar compositions are described, for example, in EP 445624.

Further common additives (D) - depending on the intended use - include optical brighteners, fillers, e.g. kaolin, talc, barytes, gypsum, chalk or silicatic fillers, pigments, dyes, wetting agents or flow improvers.

For the curing of thick and pigmented coatings it is appropriate to add glass microbeads or pulverized glass fibres, as described for example in US 5,013,768.

The formulations may also comprise dyes and/or white or coloured pigments. Depending on the intended application, both organic and inorganic pigments may be used. Such additions are known to the person skilled in the art; some examples are titanium dioxide pigments, of, for example, the rutile or anatase type, carbon black, zinc oxide, such as zinc white, iron oxides, such as yellow iron oxide, red iron oxide, chrome yellow, chrome green, nickel titanium yellow, ultramarine blue, cobalt blue, bismuth vanadate, cadmium yellow or cadmium red. Examples of organic pigments are monoazo or disazo pigments, and also metal complexes thereof, phthalocyanine pigments, polycyclic pigments, such as perylene, anthraquinone, thioindigo, quinacridone or triphenylmethane pigments, and also diketo-pyrrolopyrrole, isoindolinone, e.g. tetrachloroisoindolinone, isoindoline, dioxazine, benzimidazolone and quinophthalone pigments.

The pigments may be used individually or else in a mixture in the formulations.

The pigments, depending on the intended use, are added to the formulations in the amounts customary in the art, for example in an amount of from 1 to 60% by weight, or from 10 to 30% by weight, based on the overall mass.

The formulations may also, for example, comprise organic dyes from a very wide variety of classes. Examples are azo dyes, methine dyes, anthraquinone dyes or metal complex dyes. Customary concentrations are, for example, from 0.1 to 20%, in particular from 1 to 5%, based on the overall mass.

The choice of additives is guided by the respective field of application and by the properties desired for this field. The above-described additives (D) are customary in the art and, accordingly, are used in the amounts that are customary in the art.

### Additional Photoinitiators (E)

Examples are:

### Benzophenones of the formula

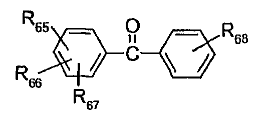

wherein
**R₆₅**, **R₆₆** and **R₆₇** independently of one another are hydrogen, C₁-C₄-alkyl, C₁-C₄-halogenalkyl, C₁-C₄-alkoxy, chlorine or N(C₁-C₄-alkyl)₂;
**R₆₈** is hydrogen, C₁-C₄-alkyl, C₁-C₄-halogenalkyl, phenyl, N(C₁-C₄-alkyl)₂, COOCH₃, 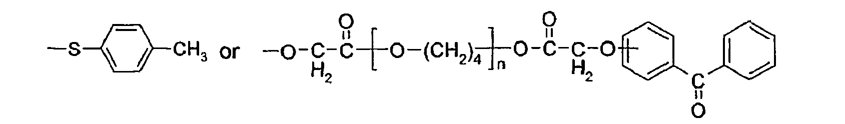 with n being 2-10.

Examples are:
ESACURE TZT^{®} available from Lamberti, (a mixture of 2,4,6-trimethylbenzophenone and 4-methylbenzophnone.
Benzophenone, Darocur^{®} BP.

### Alpha-hydroxyketones, alpha-alkoxyketones or alpha aminoketones of the formula

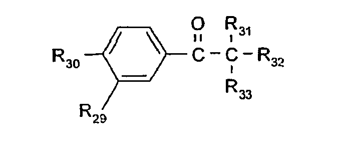

wherein
**R₂₉** is hydrogen or C₁-C₁₈-alkoxy;
**R₃₀** is hydrogen, C₁-C₁₈-alkyl, C₁-C₁₈-alkoxy, -OCH₂CH₂-O**R₄₇**, morpholino, SCH₃, a group 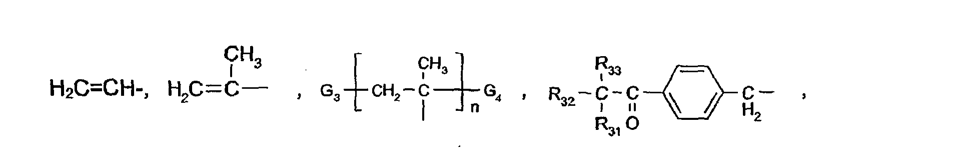 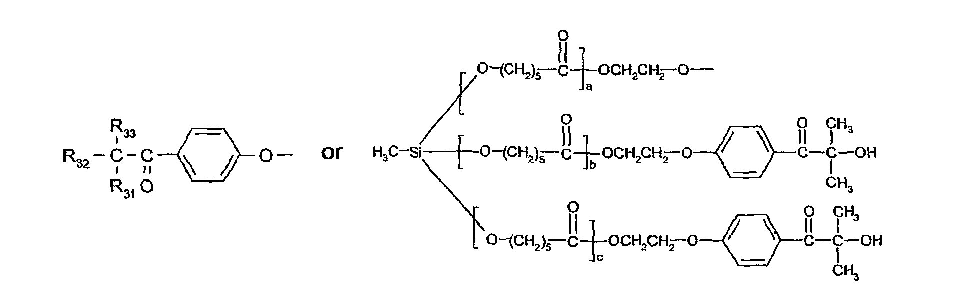 **a**, **b** and **c** are 1-3;
**n** is 2-10;
**G₃** and **G₄** independently of one another are end groups of the polymeric structure, preferably hydrogen or methyl;
**R₄₇** is hydrogen, 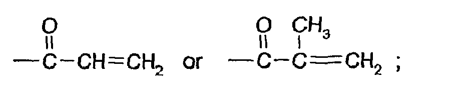 **R₃₁** is hydroxy, C₁-C₁₆-alkoxy, morpholino, dimethylamino or -O(CH₂CH₂O)ₘ-C₁-C₁₆-alkyl;
**R₃₂** and **R₃₃** independently of one another are hydrogen, C₁-C₆-alkyl, C₁-C₁₆-alkoxy or -O(CH₂CH₂O)ₘ-C₁-C₁₆-alkyl; or unsubstituted phenyl or benzyl; or phenyl or benzyl substituted by C₁-C₁₂-alkyl; or R₃₂ and R₃₃ together with the carbon atom to which they are attached form a cyclohexyl ring; **m** is 1-20;
with the proviso that R₃₁, R₃₂ and R₃₃ not all together are C₁-C₁₆-alkoxy or -O(CH₂CH₂O)ₘ-C₁-C₁₆-alkyl.

Examples are:
1-Hydroxy-cyclohexyl-phenylketone (IRGACURE^{®}184) or IRGACUR^{®} 500 (a mixture of IRGACURE^{®} 184 with benzophenone);
2-Methyl-1[4-(methylthio)phenyl]-2-morpholinopropan-1-one (IRGACURE^{®}907); 2-Benzyl-2-dimethylamino-1-(4-morpholinophenyl)-butanone-1 (IRGACURE^{®}369); 1-[4-(2-Hydroxyethoxy)-phenyl]-2-hydroxy-2-methyl-1-propane-1-one (IRGACURE^{®}2959);
2,2-Dimethoxy-1,2-diphenylethan-1-one (IRGACURE^{®}651);
2-Hydroxy-2-methyl-1-phenyl-propan-1-one; (DAROCUR ^{®} 1173).
2-Dimethylamino-2-(4-methyl-benzyl)-1-(4-morpholin-4-yl-phenyl)-butan-1-one; (IRGACURE^{®} 379)
2-Benzyl-1-(3,4-dimethoxy-phenyl)-2-dimethylamino-butan-1-one;
2-Hydroxy-1-{4-(4-(2-hydroxy-2-methyl-propionyl)-phenoxy]-phenyl}-2-methyl-propan-1-one.

Another example of an alpha hydroxy ketone is a compound of the formula 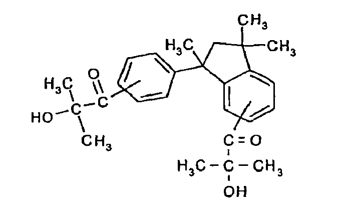 for example, ESACURE KIP from Fratelli Lamberti, 2-hydroxy-1-{1-[4-(2-hydroxy-2-methylpropionyl)-phenyl]-1,3,3-trimethyl-indan-5-yl}-2-methyl-propan-1-one.

Irgacure- and Darocur-products are available from Ciba Specialty Chemicals Inc.

### Acylphosphine oxides of the formula

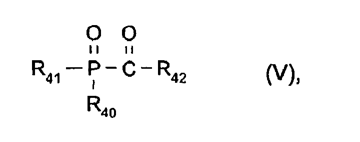

wherein
**R₄₀** ad **R₄₁** independentliy of one another are unsubstituted C₁-C₂₀-alkyl, cyclohexyl, cyclopentyl, phenyl, naphthyl or biphenylyl; or C₁-C₂₀-alkyl, cyclohexyl, cyclopentyl, phenyl, naphthyl or biphenylyl substituted by halogen, C₁-C₁₂-alkyl, C₁-C₁₂-alkoxy, C₁-C₁₂alkylthio or N**R₅₂R₅₃**, or **R₄₀** and **R₄₁** are independently of one another -(CO)**R₄₂**, wherein
R₅₂ and R₅₃ independently of one another are hydrogen, unsubstituted C₁-C₁₂-alkyl or C₁-C₁₂-alkyl substituted by OH or SH whereby the alkyl chain may be interrupted by one to four oxygen atoms; or R₅₂ and R₅₃ independently of one another are C₂-C₁₂-alkenyl, cyclopentyl, cyclohexyl, benzyl or phenyl;
**R₄₂** is unsubstituted cyclohexyl, cyclopentyl, phenyl, naphthyl or biphenylyl or cyclohexyl, cyclopentyl, phenyl, naphthyl or biphenylyl substituted by halogen, C₁-C₄-alkyl and/or C₁-C₄-alkoxy; or **R₄₂** is a 5- or 6-membered heterocyclic ring having an S atom or N atom.

Examples are:
bis(2,4,6-trimethylbenzoyl)-phenylphosphineoxide IRGACURE ^{®}819;
2,4,6-trimethylbenzoyl-diphenyl-phosphinoxide; Darocur^{®} TPO;
bis(2,6-dimethoxybenzoyl)-2,4,4-trimethyl pentylphosphineoxide.

### Titanocenes of the formula

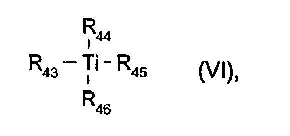

wherein
**R₄₃** and **R₄₄** idependently of one another are cyclopentadienyl optionally mono-, di-, or trisubstituted by C₁-C₁₈-alkyl, C₁-C₁₈-alkoxy, cyclopentyl, cyclohexyl or halogen;
**R₄₅** and **R₄₆** are phenyl having at least one F- or CF₃-substituent in ortho position to the Ti-C bond and having at least a further substituent which is unsubstituted pyrrolinyl or polyoxaalkyl or which is pyrrolinyl or polyoxaalkyl substituted by one or two C₁-C₁₂-alkyl, di(C₁-C₁₂-alkyl)aminomethyl, morpholinomethyl, C₂-C₄-alkenyl, methoxymethyl, ethoxymethyl, trimethylsilyl, formyl, methoxy or phenyl; or
**R₄₅** and **R₄₆** are 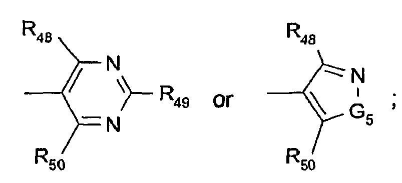 wherein
**G₅** is O, S, or N**R₅₁** with **R₅₁** being C₁-C₈alkyl, phenyl or cyclophenyl;
**R₄₈**, **R₄₉** and **R₅₀** independently of one another are hydrogen, halogen, C₂-C₁₂-alkenyl, C₁-C₁₂alkoxy, C₂-C₁₂-alkoxy interrupted by one to four oxygen atoms, cyclohexyloxy, cyclopentyloxy, phenoxy, benzyloxy, unsubstituted phenyl or biphenyl or phenyl or biphenyl substituted by C₁-C₄-alkoxy, halogen, phenylthio or C₁-C₄-alkylthio,
with the proviso that R₄₈ and R₅₀ are not both hydrogen and that with respect to
residue 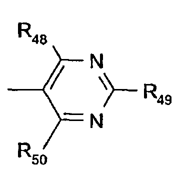 at least one substituent R₄₈ or R₅₀ is C₁-C₁₂alkoxy or

C₁-C₁₂alkoxy interrupted by one to four oxygen atoms, cyclohexyloxy, cyclopentyloxy, phenoxy or benzyloxy.

Examples are:
Bis(.eta.5-2,4-cylcopentadien-1-yl)-bis(2,6-difluoro-3-(1H-pyrrol-1-yl)-phenyl) titanium IRGACURE® 784;
Bis(2,6-difluorophenyl)bis[(1,2,3,4,5-eta)-1-methyl-2,4-cyclopentadien-1-yl] -titanium IRGACURE® 727.

### Phenylglyoxalates of the formula

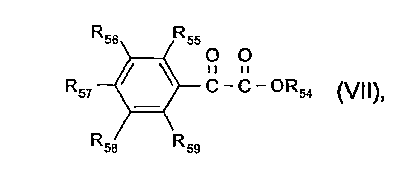

wherein **R₅₄** is hydrogen, C₁-C₁₂-alkyl, C₁-C₁₂-alkyl interrupted by oxygen and substituted by OH or a group 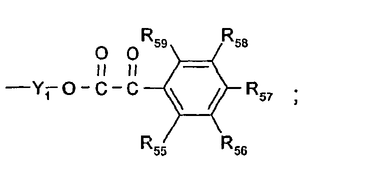 **R₅₅, R₅₆**, **R₅₇**, **R₅₈** and **R₅₉** independently of one another are hydrogen, unsubstituted C₁-C₁₂-alkyl or C₁-C₁₂-alkyl substituted by OH, C₁-C₄-alkoxy, phenyl, naphthyl, halogen or CN; and whereby the alkyl chain may be interrupted by one or more oxygen atoms; or R₅₅,
R₅₆, R₅₇, R₅₈ and R₅₉ independently of one another are C₁-C₄-alkoxy, C₁-C₄-alkythio or N**R₅₂R**_{**53**;}
**R₅₂** and **R₅₃** independently of one another are hydrogen, unsubstituted C₁-C₁₂-alkyl or C₁-C₁₂-alkyl substituted by OH or SH whereby the alkyl chain may be interrupted by one to four oxygen atoms; or R₅₂ and R₅₃ independently of one another are C₂-C₁₂-alkenyl, cyclopentyl, cyclohexyl, benzyl or phenyl;
Y₁ is C₁-C₁₂-alkylene optionally interrupted by one or more oxygen.

An Example is oxo-phenyl-acetic acid 2-[2-(2-oxo-2-phenyl-acetoxy)-ethoxy]-ethyl ester. (IRGACURE ^{®}754)

### Surface active photoinitiators

**Surface active benzophenones as described** in WO 02/48204 of the formula 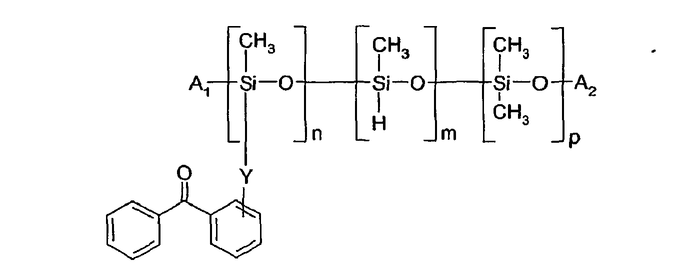 wherein
- A₁: is methyl or -O-Si(CH₃)₃;
- A₂: is methyl or -Si(CH₃)₃;
- Y: is -(CH₂)ₐ -(CH₂)ₐ-O-, -(CH₂)_{b}-O-(CH₂)ₐ- or -(CH₂)_{b}-O-(CH₂)ₐ-O-;
- a and b: are independently of one another 1-10;
- n: is a number from 1 to 10;
- m: is a number from 0 to 25;
- p: is a number from 0 to 25.

An example is

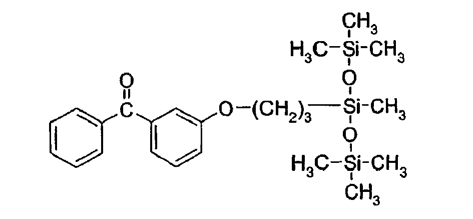

Siloxane-modified hydroxy- ketones as described in EP 1072326_ 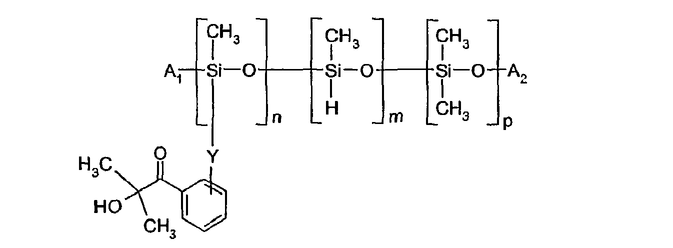 wherein
- A₁: is methyl or -O-Si(CH₃)₃;
- A₂: is methyl or -Si(CH₃)₃;
- Y: is **-**(CH₂)ₐ**-** -(CH₂)ₐ-O-, -(CH₂)_{b}-O-(CH₂)ₐ- or -(CH₂)_{b}-O-(CH₂)ₐ-O-;
- a and b: are independently of one another 1-10;
- n: is a number from 1 to 10;
- m: is a number from 0 to 25;
- p: is a number from 0 to 25.

An example is

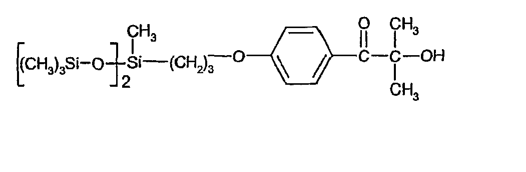

**Surface active benzil dialkyl ketals (BDK) or benzoins** as described in WO 02/48203 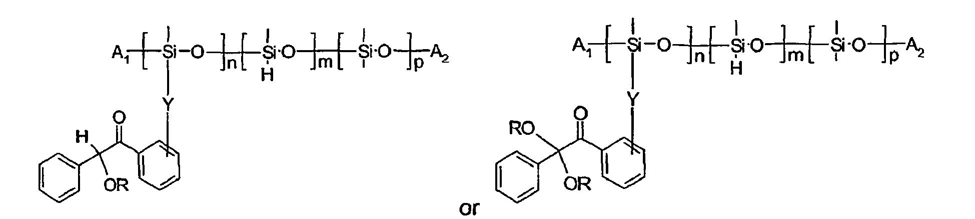 wherein
- R: is H or C₁-C₄alkyl;
- A₁: is methyl or -O-Si(CH₃)₃;
- A₂: is methyl or -Si(CH₃)₃;
- Y: is -(CH₂)ₐ- -(CH₂)ₐ-O-, -(CH₂)_{b}-O-(CH₂)ₐ or -(CH₂)_{b}-O-(CH₂)ₐ-O-;
- a and b: are independently of one another 1-10;
- n: is a number from 1 to 10;
- m: is a number from 0 to 25;
- p: is a number from 0 to 25.

Examples are

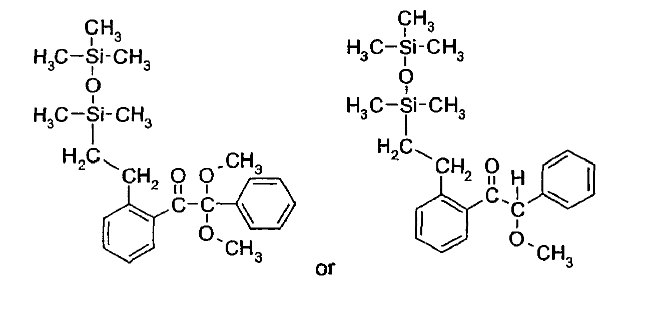

**Monomeric and dimeric arylglyoxalic acid esters modified with siloxane *via* an ester group** as described in WO 02/14439. 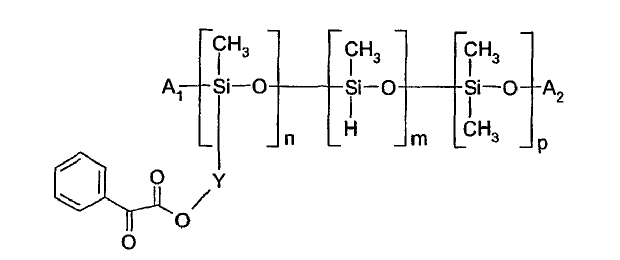 wherein
- A₁: is methyl or -O-Si(CH₃)₃;
- A₂: is methyl or -Si(CH₃)₃;
- Y: is -(CH₂)ₐ **-(CH₂)ₐ-O-, -(CH₂)_{b}-O-(CH2)ₐ-** or -(CH₂)_{b}-O-(CH₂)ₐ-O-;
- a and b: are independently of one another 1-10;
- n: is a number from 1 to 10;
- m: is a number from 0 to 25;
- p: is a number from 0 to 25.

An Example is

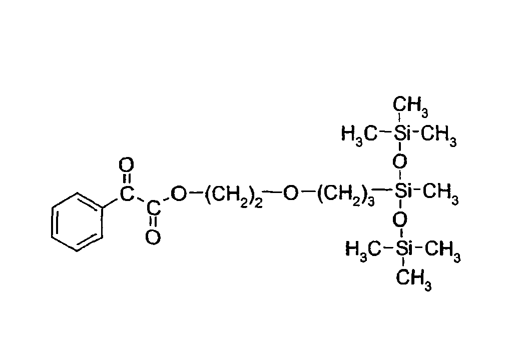

**Monomeric and dimeric arylglyoxalic acid esters modified with siloxane *via* an aromatic group** as described in WO 02/14326 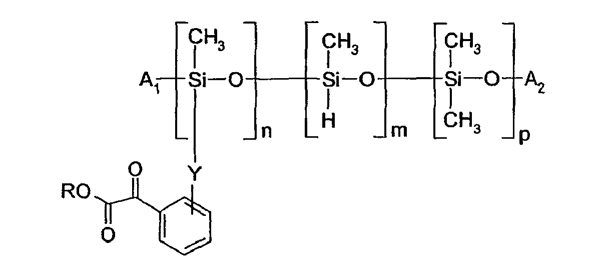 wherein
- R: is C₁-C₄alkyl;
- A₁: is methyl or -O-Si(CH₃)₃;
- A₂: is methyl or -Si(CH₃)₃;
- Y: is -(CH₂)ₐ- -(CH₂)ₐ-O-, -(CH₂)_{b}-O-(CH₂)ₐ- or -(CH₂)_{b}-O-(CH₂)ₐ-O-;
- a and b: are independently of one another 1-10;
- n: is a number from 1 to 10;
- m: is a number from 0 to 25;
- p: is a number from 0 to 25.

An Example is

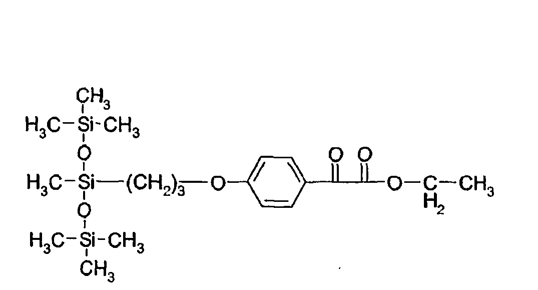

Long-chain alkyl modified hydroxy- ketones as described in WO 02/48202, for example 1-(4-Docosyloxy-phenyl)-2-hydroxy-2-methyl-1-propanone

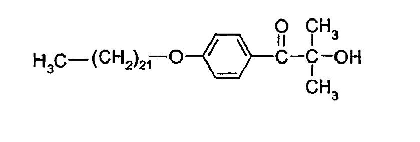

Fluorinated modified hydroxyketones as described in WO02/40602, for example heptafluorobutyric acid 1-(4-hydroxybenzoyl)-1-methylethyl ester

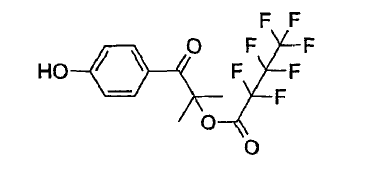

A further example of a photoinitiator is Esacure 1001 available from Lamberti 1-[4-(4-benzoylphenylsulfanyl)phenyl]-2-methyl-2-(4-methylphenylsulfonyl)propan-1-one

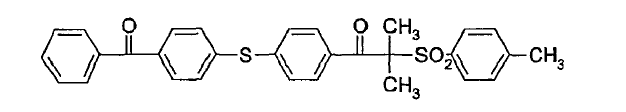

Other known photoinitiators (E) are, for example, mixtures with camphorquinone, acetophenones, 4-aroyl-1,3-dioxolanes, benzoin alkyl ethers and benzil ketals, such as benzil dimethyl ketal, peresters, for example benzophenonetetracarboxylic peresters as described, for example, in EP 126541, halomethyltriazines, e.g. 2-[2-(4-methoxyphenyl)-vinyl]-4,6-bistrichloromethyl[1,3,5]triazine, 2-(4-methoxyphenyl)-4.,6-bistrichloromethyl-[1,3,5]triazine, 2-(3,4-dimethoxyphenyl)-4,6-bistrichloromethyl[1,3,5]triazine, 2-methyl-4,6-bistrichloromethyl[1,3,5]triazine, hexaarylbisimidazole / coinitiator systems, e.g. ortho-chloro-hexaphenylbisimidazole together with 2-mercaptobenzothiazole, ferrocenium compounds or borate photoinitiators.

Where the photoinitiators of the invention are employed in hybrid systems, i.e. systems which can be cured both free-radically and cationically, use is made, in addition to the free-radical curing agents of the formula I or II and any further free-radical curing agents, of cationic photoinitiators such as benzoyl peroxide (other suitable peroxides are described in US 4,950,581, column 19, lines 17-25), aromatic sulfonium, phosphonium or iodonium salts, as described for example in US 4,950,581, column 18, line 60 to column 19, line 10.

The photopolymerizable compositions contain the photoinitiator appropriately in an amount of from 0.05 to 15% by weight, preferably from 0.1 to 5% by weight, based on the composition. The stated amount of photoinitiator is based on the sum of all of the added photoinitiators, if mixtures thereof are used, i.e. both on the photoinitiator (B) and on the photoinitiators (B) + (E).

In certain cases it may be of advantage to use mixtures of two ore more photoinitiators. The photopolymerizable compositions may be used for a variety of purposes: for example, as a printing ink, as a clearcoat material, preferably a clearcoat over an automotive base coat; as a white paint or as a chromatically pigmented paint for wood or metal, for example, as powder coating materials, as coating material for wood, textiles, paper, ceramic, glass, plastics such as polyesters, polyethylene terephthalate, polyolefins or cellulose acetate, especially in the form of films; as a daylight-curable coating for the marking of buildings and roads, for photographic reproduction techniques, for holographic recording materials, for image recording techniques or for producing printing plates which can be developed with organic solvents or using aqueous alkalis, for producing masks for screen printing, as dental filling compounds, as adhesives, including pressure-sensitive adhesives, as laminating resins, as etch resists or permanent resists, both liquid and in the form of dry films, as photostructurable dielectrics, as solder resists for electronic circuits, as resists for producing colour filters for any type of screen, or for producing structures in the production process of plasma displays and eletroluminescent displays, for the production of optical switches, optical lattices (interference grids), for the production of three-dimensional articles by mass curing (UV curing in transparent moulds) or by the stereolithography process, as described for example in US 4,575,330, for producing composite materials (e.g. styrenic polyesters which may where appropriate contain glass fibres and/or other fibres and other auxiliaries), and of gel coats and high-film-build compositions, for the coating or sealing of electronic components, or as coatings for optical fibres. The compositions are suitable, furthermore, for the production of optical lenses, e.g. contact lenses or Fresnel lenses, and also for producing medical instruments, aids or implants.

The compositions may also be used to produce gels having thermotropic properties, as described for example in DE 19700064 and EP 678534.

The compounds of the formula I or II may additionally be used as initiators for emulsion, bead or suspension polymerizations or as initiators in a polymerization for the fixing of states of order of liquid-crystalline monomers and oligomers, or as initiators for the fixing of dyes on organic materials.

The photocurable compositions of the invention are suitable, for example, as coating materials for substrates of all kinds, e.g. wood, textiles, paper, ceramic, glass, plastics such as polyesters, polyethylene terephthalate, polyolefins or cellulose acetate, especially in the form of films, and also metals such as AI, Cu, Ni, Fe, Zn, Mg or Co and GaAs, Si or Si0₂, to which a protective coat or - by imagewise exposure - an image is to be applied.

The substrates may be coated by applying a liquid composition, a solution or suspension to the substrate. The choice of solvent and the concentration are guided primarily by the nature of the composition and by the coating technique. The solvent should be inert, i.e. it should not enter into any chemical reaction with the components and it should be able to be removed again in the course of drying after coating. Examples of suitable solvents are ketones, ethers and esters, such as methyl ethyl ketone, isobutyl methyl ketone, cyclopentanone, cyclohexanone, N-methylpyrrolidone, dioxane, tetrahydrofuran, 2-methoxyethanol, 2-ethoxyethanol, 1-methoxy-2-propanol, 1,2-dimethoxyethane, ethyl acetate, n-butyl acetate and ethyl 3-ethoxypropionate.

The formulation is applied uniformly to a substrate by means of known coating techniques, for example by spincoating, dipping, knife coating, curtain coating techniques, brush application, spraying, especially by electrostatic spraying, and reverse roll coating, and also by electrophoretic deposition. It is also possible to apply the photosensitive layer to a temporary flexible support and then, by layer transfer via lamination, to the final substrate.

The application (coat thickness) and nature of the substrate (coat support) are dependent on the desired field of application. The dry film thickness range generally embraces values from about 0.1 µm to more than 100 µm.

A further field of use of photocuring is that of metal coating, as in the coating of metal sheets and tubes, cans or bottle closures, for example, and also photocuring on polymer coatings, for example PVC-based wall or floor coverings.

Examples of the photocuring of paper coatings are the colourless varnishing of labels, record sleeves or book covers.

The photosensitivity of the compositions of the invention generally ranges from about 200 nm to about 600 nm (UV region). Suitable radiation is present, for example, in sunlight or light from artificial sources. Light sources employed therefore include a large number of a very wide variety of types. Both point sources and arrays (lamp carpets) are suitable. Examples are carbon arc lamps, xenon arc lamps, medium-, high- and low-pressure mercury lamps, possibly doped with metal halides (metal-halogen lamps), microwave-excited metal vapour lamps, excimer lamps, superactinic fluorescent tubes, fluorescent lamps, argon incandescent lamps, flashlights, photographic floodlamps, light-emitting diodes (LEDs), electron beams and X-rays generated by means of laser plasma or microwave plasma. The distance between the lamp and the substrate to be exposed may vary depending on the intended application and the type and output of the lamps, for example between 2 cm and 150 cm.

As already mentioned, curing in the process of the invention may take place solely by exposure to electromagnetic radiation. Depending on the composition of the formulation to be cured, however, thermal curing before, during or after radiation exposure is appropriate.

Thermal curing takes place in accordance with methods known to the person skilled in the art. Curing is generally carried out in an oven, e.g. a forced-air oven, on a hotplate, or by irradiation using NIR lamps or IR lamps. Curing without auxiliaries at room temperature is likewise possible, depending on the binder system used. The curing temperatures are generally between room temperature and 150°C, e.g. 25-150°C or 50-150°C. In the case of powder coating materials or coil coating materials, the curing temperatures may also be higher, e.g. up to 350°C.

Where the formulation includes thermally curable components (C), it is additionally possible in accordance with the invention to add thermal drying catalysts or curing catalysts to the formulation as additional additives (D). Examples of possible drying catalysts, or thermal curing catalysts, are organometallic compounds, amines and/or phosphines. Organometallic compounds are, for example, metal carboxylates, especially those of the metals Pb, Mn, Co, Zn, Hf, Zr or Cu, or metal chelates, especially those of metals Al, Ti, Hf or Zr, or organometallic compounds such as organotin compounds. Examples of metal carboxylates are the stearates of Pb, Mn or Zn, the octoates of Co, Zn or Cu, the naphthenates of Mn and Co or the corresponding linoleates or tallates. Examples of metal chelates are the aluminium, titanium or zirconium chelates of acetylacetone, ethyl acetylacetate, salicylaldehyde, salicyl-aldoxime, o-hydroxyacetophenone or ethyl trifluoroacetylacetate and the alkoxides of these metals. Examples of organotin compounds are dibutyltin oxide, dibutyltin dilaurate and dibutyltin dioctoate. Examples of amines are, in particular, tertiary amines, such as tributylamine, triethanolamine, N-methyldiethanolamine, N-dimethylethanolamine, N-ethylmorpholine, N-methylmorpholine or diazabicyclooctane (triethylenediamine) and also the salts thereof. Further examples are quaternary ammonium salts, such as trimethylbenzylammonium chloride. As curing catalysts it is also possible to use phosphines, such as triphenylphosphine. Suitable catalysts are described, for example, as well in J. Bieleman, Lackadditive [Additives for Coatings], Wiley-VCH Verlag GmbH, Weinheim, 1998, page 244-247. Examples are sulfonic acids, such as p-toluenesulfonic acid, dodecylbenzenesulfonic acid, dinonylnaphthalenesulfonic acid or dinonylnaphthalenedisulfonic acid. For example, it is also possible to use latent or blocked sulfonic acids, where the blocking of the acid may be ionogenic or non-ionogenic.

Such catalysts are used in the concentrations known to the person skilled in the art and customary in that art.

The inventive compositions are preferably used for producing pigmented and unpigmented paints and varnishes, powder coating materials, gel coats, composite materials, glass fibre coatings, inks or ink jet inks.

The invention likewise provides a coated substrate coated on at least one surface with a composition as described above.

The examples which follow illustrate the invention.

### Examples:

### Example 1

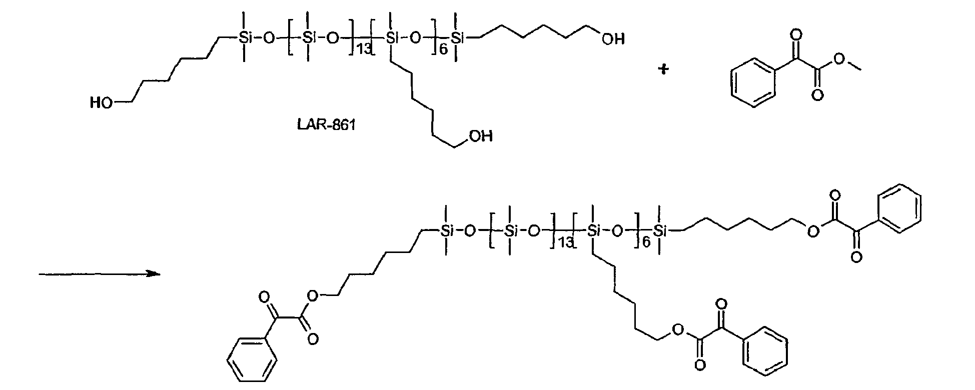

6.01 g (21.0 mmol OH) LAR-861 (Degussa), 4.9ml (5.7g, 34mmol) methyl phenylglyoxalate and 0.34 g (3.3 mmol) lithium acetate dihydrate are placed in a 100 ml flask. The mixture is heated to 120°C under vacuum (250 mbar) for 4 days. 40ml toluene is added and the slurry is filtered. Removal of volatiles in vacuo and vacuum distillation of the remaining methyl ester give a slightly yellow oil. Yield, 8.27 g. ¹H NMR shows approximately 83% conversion of OH groups to the ester. ¹H NMR (CDCl₃, 300 MHz, ppm): 7.96, 7.58, 7.45, 4.31, 3.56, 1.70, 1.47 (unreacted C*H*₂CH₂OH), 1.30, 0.45, -0.03.

### Example 2

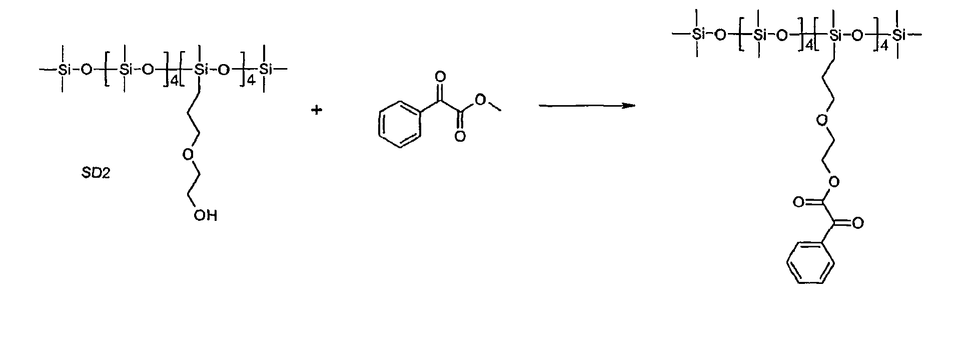

242.4 g (0.22 mol OH) SD2 (Wacker Chemie), 158.9 g (0.968 mol) methyl phenylglyoxalate and 9.0 g (0.088 mol) lithium acetate dihydrate are placed in a 1.5 l rector. The mixture is heated to 100°C under vacuum (30 mbar) for 22 hours. 250 ml toluene is added and the product is filtered. The toluene and excess methyl ester are distilled in vacuo to give a slightly yellow oil. Yield, 329.8 g (95%).
¹H NMR shows approximately 90% conversion of OH groups to the ester. ¹H NMR (CDCl₃, 300 MHz, ppm): 7.95, 7.58, 7.43, 4.46, 3.67, 3.37, 1.55, 0.44, 0.01.

### Example 3

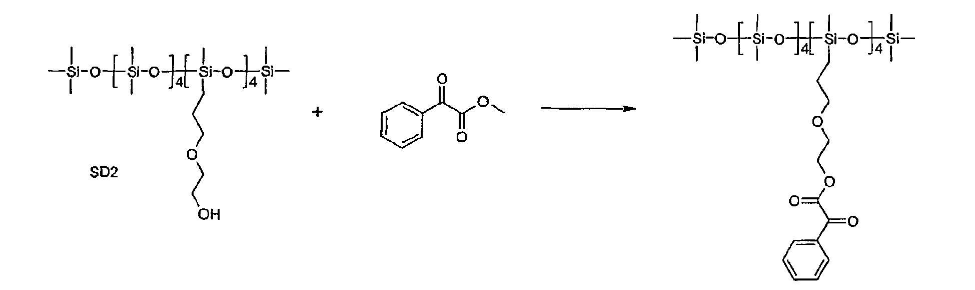

4.41 g (16.0 mmol OH) SD2 (Wacker Chemie), 2.90 g (17.7 mmol) methyl phenylglyoxalate, and 0.44g Novo 435 enzyme [recombinant Candida antarctica lipase B (E. M. Anderson et al. Biocat. Biotransf. 1998, 16, 181), Firma NOVO Nordisk, Bagswaerd, Dänemark] are placed in a 100 ml flask. The mixture is heated to 50°C under vacuum (30 mbar) for 3 days. 10 ml toluene is added and the product is filtered. The toluene and excess methyl ester are distilled in vacuo to give a slightly yellow oil. Yield, 5.05 g (80%).
¹H NMR shows approximately 84% conversion of OH groups to the ester. Analysis identical to the product from Example 2.

### Application Examples

### Example A1 UV-curable clearcoat, dual cure system

| parts by wt | Component A |
|---|---|
| 11.38 | Desmophen A 870 hydroxyl functional polyacrylate (70 %) in butylacetate, Bayer AG |
| 21.23 | Desmophen VP LS 2089 (polyesterpolyol (75 %) in butylacetate) Bayer AG |
| 0.55 | Byk 306 (Flow agent) Byk Chemie |
| 32.03 | Methanol |
| | Component B |
| 32.09 | Roskydal UA VP LS 2337 (isocyanate functional urethane acrylate) Bayer |
| | Component C |
| 0.17 | lrgacure 819 |
| 1.52 | Initiator, see Table 1 |
| 0.85 | Tinuvin 400 |
| 0.56 | Tinuvin 292 |

Irgacure 819: Bis(2,4,6-trimethylbenzoyl)-phenylphosphineoxide
Tinuvin 400: a mixture of:2-[4-[(2-Hydroxy-3-dodecyloxypropyl)oxy]-2-hydroxyphenyl]-4,6-bis(2,4-dimethylphenyl)-1,3,5-triazine and 2-[4-[(2-Hydroxy-3-tridecyloxypropyl)oxy]-2-hydroxyp henyl]-4,6-bis(2,4-dimethylphenyl)-1,3,5-triazine Tinuvin 292 Methyl(1,2,2,6,6-pentamethyl-4-piperidinyl)sebacate

Photoinitiators and light stabilisers, which are mentioned in Component C and Table 1 are well dissolved in component A. Subsequent component B is added and well homogenised.

The mixtures are applied to white coil-coat aluminum, air-dried for 5 minutes at room temperature and heated by means of a hot plate at 120 °C for 10 minutes. Irradiation is then carried out using a UV-processor (2X120 W/cm) Mercury medium pressure Lamps at a belt speed of 5 m/min. A tack free dry film with a thickness of approximately 40 µm is obtained.

45 minutes after cure, the pendulum hardness according to König (DIN 53157) is measured. Surface energy of the coating is determined by measuring static water contact angle (θ) using a contact angle measuring system G10 from Kruss. The higher the value of pendulum hardness, the harder is the cured surface. The higher the contact angle, the better is the moisture resistance and scratch resistance. In addition the Gloss is measured according to DIN 67 530. The higher the Gloss values at 20° is than better is the surface property.

The results are shown in Table. 1

The comparative compound is Example 24 of WO 02/14439.

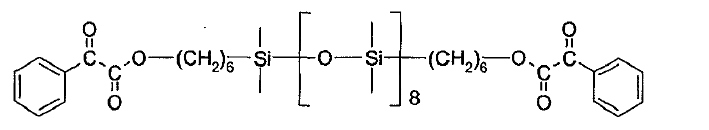

**Table 1**

| Initiator | pendulum hardness [sec] | water contact angle θ | Gloss 20° |
|---|---|---|---|
| Example 1 | 84 | 89 | |
| Example 2 | 83 | 90 | 85 |
| Comparative | 77 | 90 | 75 |

### Example A2

### UV-Cure

| parts by wt | Component |
|---|---|
| 44.5 | Ebecryl 284 (88parts aliphatic urethane acrylate /12 parts hexandiol diacrylate) UCB Chemicals |
| 32.2 | Roskydal UA VP LS 2308 (aliph. urethane tri/tetraacrylate ) Bayer |
| 10 | TMPTA Trimethylolpropyltriacrylate |
| 10 | TPGDA Tripropylenglycoldiacrylate |
| 0.5 | Glide 100 (Flow agent Tego Chemicals) |
| 2.7 | Initiator (see Tab. 2) |
| 0.5 | Irgacure 819 |
| 1.5 | Tinuvin 400 |
| 1.0 | Tinuvin 292 |

The mixtures are applied to white coil-coat aluminum. Irradiation is carried out using a UV-processor (2X120 W/cm) Mercury medium pressure Lamps at a belt speed of 5 m/min. A tack free dry film with a thickness of approximately 40 µm is obtained.

45 minutes after cure, the pendulum hardness according to König (DIN 53157) is measured. Surface energy of the coating is determined by measuring static water contact angle (θ) using a contact angle measuring system G10 from Krüss. The higher the value of pendulum hardness, the harder is the cured surface. The higher the contact angle, the better is the moisture resistance and scratch resistance. In addition the Gloss is measured according to DIN 67 530. The higher the Gloss values at 20° is than better is the surface property. The results are shown in Table. 2

The comparative compound is Example 24 of WO 02/14439.

**Table 2**

| Initiator | pendulum hardness [sec] | water contact angle θ | Gloss 20° |
|---|---|---|---|
| Example 1 | 116 | 91 | |
| Example 2 | 127 | 90 | 80 |
| Comparative | 112 | 87 | 51 |

## Claims

1. Polymeric photoinitiators of the formula I or II 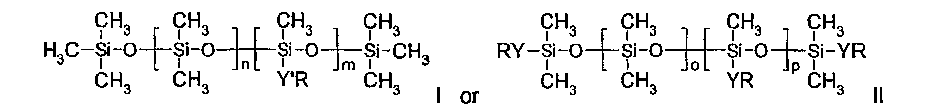 wherein
n and m independently of one another are 3-5;
o is 10-16;
p is 4-8;
R is phenyl-CO-CO-O-;
Y and Y' independently of one another are C₁-C₁₀alkylene or -[(CH₂)ₐ-O-(CH2)_{b}]_{c}- wherein
a is 2-10, b is 0-10, c is 1-3; with the proviso that they are, however, at least 1 if the
methylene group in question is between two oxygen atoms.

2. A process for preparing the polymeric photoinitiator of the formula I or II as defined in claim 1 by reacting a phenyl glyoxalic acid C₁-C₆alkylester with an OH- or amino terminated organosilicon compound of the formula I' or II' 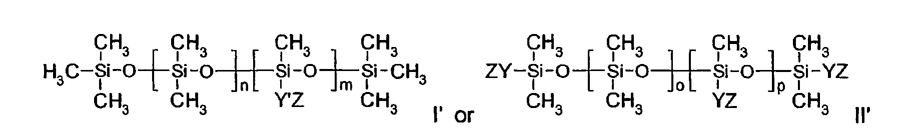 wherein Y and Y' are as defined in claim 1 and Z is OH or NH₂
in the presence of an enzyme which catalyzes the esterification, transesterification or amidation reaction.

3. A photocurable composition comprising
(A) at least one ethylenically unsaturated free-radically photopolymerizable compound; and
(B) at least one surface-active photoinitiator of the formula I or II;
(C) optionally thermally crosslinkable compounds;
(D) optionally further additives;
(E) optionally further photoinitiators.

4. A composition according to claim 3, comprising in addition to components (A) and (B), or (A), (B) and (C), further additives (D) and/or additional photoinitiators (E).

5. A process for producing coatings having scratch-resistant and/or chemical resistant surfaces, in which a photocurable composition of claim 3 or 4 is applied to a substrate; and the formulation is cured either only by exposure to electromagnetic radiation with a wavelength ranging from 200 nm into the NIR (near infrared) region or into the IR region, or by exposure to electromagnetic radiation with a wavelength ranging from 200 nm into the NIR region or into the IR region and prior, simultaneous and/or subsequent exposure to heat.

6. A method of causing a photoinitiator to accumulate at the surface of coatings comprising ethylenically unsaturated photocurable compounds, which comprises adding a surface-active photoinitiator of the formula I or II to the photocurable mixture comprising the ethylenically unsaturated photocurable compounds.

7. The use of compounds of the formula I or II according to claim 1 as surface-active photoinitiators for the photopolymerization of ethylenically unsaturated compounds or mixtures comprising such compounds.

8. The use of compositions according to claim 3 or 4 for producing pigmented and unpigmented paints and varnishes, powder coating or powder slurry materials, gel coats, composite materials, glass fibre coatings, inks or ink jet inks.

9. A coated substrate coated on at least one surface with a composition of claim 3 or 4.

## Patentansprüche

1. Polymere Photoinitiatoren der Formel I oder II 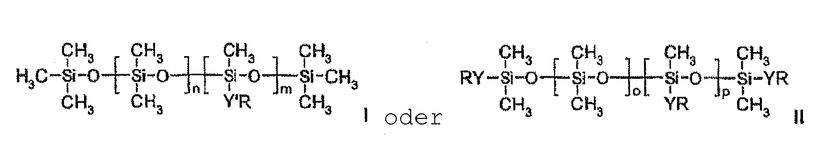 worin
n und m unabhängig voneinander für 3-5 stehen;
o für 10-16 steht;
p für 4-8 steht;
R für Phenyl-CO-CO-O- steht;
Y und Y' unabhängig voneinander für C₁-C₁₀-Alkylen oder [(CH₂)ₐ-O-(CH₂)_{b}]_{c} - stehen, worin a für 2-10 steht, b für 0-10 steht und c für 1-3 steht; aber mit der Maßgabe, daß sie mindestens für 1 stehen, wenn die betreffende Methylengruppe zwischen zwei Sauerstoffatomen steht.

2. Verfahren zur Herstellung des polymeren Photoinitiators der Formel I oder II nach Anspruch 1 durch Umsetzung eines Phenylglyoxalsäure-C₁-C₆-alkylesters mit einer OH- oder aminogruppenterminierten Organosiliciumverbindung der Formel I' oder II' 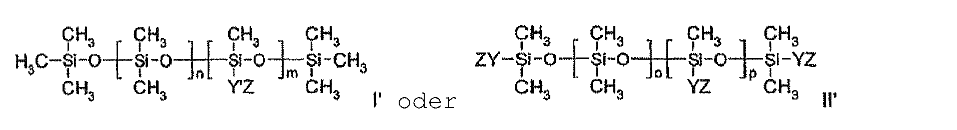 worin Y und Y' die in Anspruch 1 angegebene Bedeutung besitzen und Z für OH oder NH₂ steht,
in Gegenwart eines Enzyms, das die Veresterungs-, Umesterungs- bzw. Amidierungsreaktion katalysiert.

3. Photohärtbare Zusammensetzung, enthaltend
(A) mindestens eine ethylenisch ungesättigte radikalisch photopolymerisierbare Verbindung und
(B) mindestens einen oberflächenaktiven Photoinitiator der Formel I oder II;
(C) gegebenenfalls thermisch vernetzbare Verbindungen;
(D) gegebenenfalls weitere Additive;
(E) gegebenenfalls weitere Photoinitiatoren.

4. Zusammensetzung nach Anspruch 3, die zusätzlich zu den Kompnenten (A) und (B) bzw. (A), (B) und (C) weitere Additive (D) und/oder zusätzliche Photoinitiatoren (E) enthält.

5. Verfahren zur Herstellung von Beschichtungen mit kratzfesten und/oder chemikalienbeständigen Oberflächen, bei dem man eine photohärtbare Zusammensetzung nach Anspruch 3 oder 4 auf ein Substrat aufbringt und die Formulierung härtet, indem man sie entweder nur elektromagnetischer Strahlung mit einer Wellenlänge im Bereich von 200 nm bis in den NIR-Bereich (NIR ₌ Nahinfrarot) oder IR-Bereich aussetzt oder elektromagnetischer Strahlung mit einer Wellenlänge im Bereich von 200 nm bis in den NIR-Bereich oder IR-Bereich und vorher, gleichzeitig und/oder danach Wärme aussetzt.

6. Verfahren zur Anreicherung eines Photoinitiators an der Oberfläche von Beschichtungen, enthaltend ethylenisch ungesättigte photohärtbare Verbindungen, bei dem man der photohärtbaren Mischung, die die ethylenisch ungesättigten photohärtbaren Verbindungen enthält, einen oberflächenaktiven Photoinitiator der Formel I oder II zusetzt.

7. Verwendung von Verbindungen der Formel I oder II nach Anspruch 1 als oberflächenaktive Photoinitiatoren für die Photopolymerisation von ethylenisch ungesättigten Verbindungen oder Mischungen, die derartige Verbindungen enthalten.

8. Verwendung von Zusammensetzungen nach Anspruch 3 oder 4 zur Herstellung von pigmentierten und nichtpigmentierten Farben und Lacken, Pulverlacken oder Pulverslurries, Gelcoats, Verbundmassen, Glasfaserbeschichtungen, Tinten oder Ink-Jet-Tinten.

9. Beschichtetes Substrat, das auf mindestens einer Oberfläche mit einer Zusammensetzung nach Anspruch 3 oder 4 beschichtet ist.

## Revendications

1. Photoinitiateurs polymères de formule I ou II 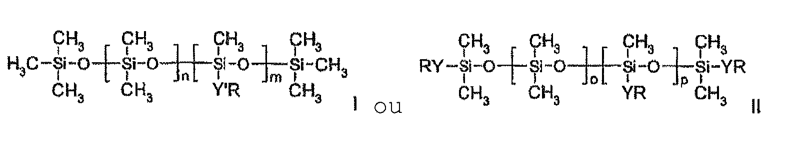 dans lesquelles
n et m indépendamment l'un de l'autre sont 3-5 ;
o est 10-16 ;
p est 4-8 ;
R est phényl-CO-CO-O- ;
Y et Y' indépendamment l'un de l'autre sont C₁-C₁₀alkylène ou -[(CH₂)ₐ-O-(CH₂)_{b}]_{c}- dans lequel a est 2-10, b est 0-10, c est 1-3 ; à condition qu'ils soient toutefois au moins égaux à 1 si le groupement méthylène en question est entre deux atomes d'oxygène.

2. Procédé de préparation d'un photoinitiateur polymère de formule I ou II telles que définies dans la revendication 1, en faisant réagir un ester C₁-C₆alkylique d'acide phényl-glyoxalique avec un composé organosilicié à extrémité OH- ou amino de formule I' ou II' 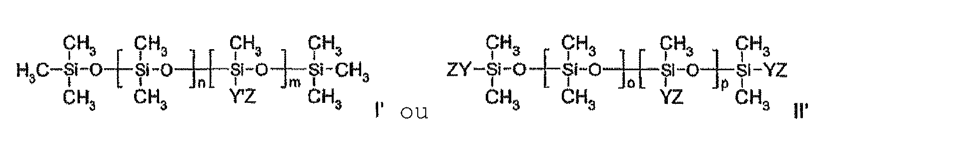 dans lesquelles Y et Y' sont tels que définis dans la revendication 1 et Z est OH ou NH₂
en présence d'une enzyme qui catalyse la réaction d'estérification, de transestérification ou d'amidation.

3. Composition photodurcissable comprenant
(A) au moins un composé éthyléniquement insaturé photopolymérisable par voie radicalaire ; et
(B) au moins un photoinitiateur tensioactif de formule I ou II ;
(C) éventuellement des composés thermiquement réticulables ;
(D) éventuellement d'autres additifs ;
(E) éventuellement d'autres photoinitiateurs.

4. Composition selon la revendication 3, comprenant, outre les composants (A) et (B), ou (A), (B) et (C), d'autres additifs (D) et/ou des photoinitiateurs supplémentaires (E).

5. Procédé de production de revêtements ayant des surfaces résistantes à l'abrasion et/ou résistantes aux produits chimiques, dans lequel une composition photodurcissable de la revendication 3 ou 4 est appliquée sur un substrat ; et la formulation est durcie soit par la seule exposition à des radiations électromagnétiques ayant une longueur d'ondes allant de 200 nm jusqu'à la région NIR (infrarouge proche) ou jusqu'à la région IR, soit par l'exposition à des radiations électromagnétiques ayant une longueur d'ondes allant de 200 nm jusqu'à la région NIR ou jusqu'à la région IR et l'exposition précédente, simultanée et/ou ultérieure à la chaleur.

6. Méthode permettant de provoquer l'accumulation d'un photoinitiateur à la surface de revêtements comprenant des composés photodurcissables éthyléniquement insaturés, qui comprend l'addition d'un photoinitiateur tensioactif de formule I ou II au mélange photodurcissable comprenant les composés photodurcissables éthyléniquement insaturés.

7. Utilisation de composés de formule I ou II selon la revendication 1 comme photoinitiateurs tensioactifs pour la photopolymérisation de composés éthyléniquement insaturés ou de mélanges comprenant de tels composés.

8. Utilisation de compositions selon la revendication 3 ou 4 pour la production de peintures et de vernis pigmentés et non pigmentés, de matériaux de revêtements en poudre ou de pâtes en poudre, de gel-coats, de matériaux composites, de revêtements de fibre de verre, d'encres ou d'encres pour jet d'encre.

9. Substrat revêtu, revêtu sur au moins une surface avec une composition selon la revendication 3 ou 4.
